# EUROPÄISCHE PATENTSCHRIFT

(11) **EP 2 398 056 B1**
(45) Veröffentlichungstag und Bekanntmachung des Hinweises auf die Patenterteilung: **02.03.2016**
(21) Anmeldenummer: 10166619.6
(22) Anmeldetag: 21.06.2010
(51) Int. Cl.: H01L 27/30, H01L 51/42

(54) **Organische Solarzelle mit mehreren Transportschichtsystemen**
Organic solar cell with several transport layer systems
Cellule solaire organique dotée de plusieurs systèmes de couches de transport

(43) Veröffentlichungstag der Anmeldung: 21.12.2011
(73) Patentinhaber: Heliatek GmbH, 01139 Dresden (DE)
(72) Erfinder: Männig, Bert, 01099 Dresden (DE); Pfeiffer, Martin, 01127 Dresden (DE); Schwartz, Gregor, 01159 Dresden (DE); Uhrich, Christian, 01307 Dresden (DE)

(56) Entgegenhaltungen:
- SCHUEPPEL RICO ET AL: "Controlled current matching in small molecule organic tandem solar cells using doped spacer layers" JOURNAL OF APPLIED PHYSICS, AMERICAN INSTITUTE OF PHYSICS. NEW YORK, US LNKD- DOI:10.1063/1.3277051, Bd. 107, Nr. 4, 17. Februar 2010 (2010-02-17), Seiten 44503-44503, XP012133492 ISSN: 0021-8979
- UHRICH CHRISTIAN ET AL: "Origin of open circuit voltage in planar and bulk heterojunction organic thin-film photovoltaics depending on doped transport layers" JOURNAL OF APPLIED PHYSICS, AMERICAN INSTITUTE OF PHYSICS. NEW YORK, US LNKD- DOI:10.1063/1.2973199, Bd. 104, Nr. 4, 29. August 2008 (2008-08-29), Seiten 43107-43107, XP012117231 ISSN: 0021-8979
- YOOK K S ET AL: "Highly Efficient p-i-n and Tandem Organic Light-Emitting Devices Using an Air-Stable and Low-Temperature-Evaporable Metal Azide as an n-Dopant", ADVANCED FUNCTIONAL MATERIALS, WILEY - V C H VERLAG GMBH & CO. KGAA, DE, vol. 20, no. 11, 9 June 2010 (2010-06-09), pages 1797-1802, XP001554438, ISSN: 1616-301X, DOI: 10.1002/ADFM.201000137 [retrieved on 2010-05-14]

## Beschreibung

Die Erfindung betrifft ein photoaktive Bauelement mit organischen Schichten, mit einer Elektrode und einer Gegenelektrode und zwischen den Elektroden mindestens zwei photoaktive Schichtsysteme und zwischen den photoaktiven Schichtsystemen zumindest zwei verschiedene Transportschichtsysteme des gleichen Ladungsträgertyps, wobei das eine Transportschichtsystem energetisch an eines der beiden photoaktiven Schichtsysteme angepasst ist und dass das andere Transportschichtsystem transparent ausgeführt ist.

Nachfolgend wird der Begriff "Schichtsystem" wie folgt definiert: Ein Schichtsystem besteht aus einer oder mehreren Schichten, wobei die jeweiligen Schichten Einzelschichten oder Mischschichten sein können. Das Schichtsystem kann damit eine beliebige Kombination aus Einzel- und Mischschichten sein.

Nachfolgend wird der Begriff "Transportschichtsystem" wie folgt definiert: Ein Transportschichtsystem ist ein Schichtsystem welches bevorzugt eine Ladungsträgersörte (Elektronen: n-Transportschichtsystem; Löcher: p-Transportschichtsystem) transportiert. Ein Transportschichtsystem trägt bei einer Solarzelle durch Absorption von Licht weniger als 5% zum Kurzschlussphotostrom bei, bevorzugt weniger als 2%.

Weiterhin wird der Begriff "verschiedene Transportschichtsysteme" wie folgt definiert: Zwei Transportschichtsysteme sind verschiedene, wenn zumindest ein Material nur in einem der beiden Transportschichtsysteme enthalten ist. Falls es sich bei diesem Material um einen Dotanden handelt, so sind die Transportschichtsysteme dann verschieden, wenn in jedem Transportschichtsystem ein anderer Dotand enthalten ist.

Der Begriff "Ladungsträgertyp" wird wie folgt definiert: Ein Ladungsträgertyp bezieht sich auf Elektronen und Löcher. In diesem Sinne sind zwei Transportschichtsysteme vom gleichen Ladungsträgertyp wenn sie beide bevorzugt Elektronen oder beide bevorzugt Löcher leiten.

Der Begriff "transparent" wird wie folgt definiert: Ein Material bzw. ein Materialfilm bzw. ein Transportschichtsystem ist transparent, wenn zumindest eine der folgenden Bedingungen zutrifft:
Der energetische Abstand zwischen LUMO und HOMO des Materials bzw. des Materialfilms bzw. des Transportschichtsystems ist > 2,5eV, bevorzugt >3,0eV.

Ein 50nm dicker Film des Materials bzw. des Transportschichtsystems hat eine Transparenz von >70% im Wellenlängenbereich von 400nm bis 900nm, bevorzugt > 80% bzw. > 90%, sehr bevorzugt > 95%.

Das Material bzw. der Materialfilm bzw. das Transportschichtsystem hat einen Extinktionskoeffizient ε, welcher im Wellenlängenbereich zwischen 450nm und 800nm den Wert von 0,5*10⁵ /cm nicht überschreitet, und/oder das Material bzw. der Materialfilm bzw. das Transportschichtsystem hat einen Absorptionsindex k, welcher im Wellenlängenbereich zwischen 450nm und 800nm den Wert 0,1 nicht überschreitet (Ein anderer Begriff für k ist auch optische Konstante: die beiden optischen Konstanten werden üblicherweise mit n und k bezeichnet).

Das Material bzw. der Materialfilm bzw. das Transportschichtsystem weist eine größere optische Bandlücke auf als das photoaktive Schichtsystem (im Sinne von DE 102004014046).

Transparente organische Materialien werden in der Literatur auch als wide-gap Materialien bezeichnet.

Die Begriffe "HOMO" und "LUMO" werden wie in der Chemie üblich als highest occupied molecular orbital und lowest unoccupied molecular orbital verstanden. Der Begriff bezieht sich dabei sowohl auf einzelne Moleküle als auch auf Festkörper bzw. Materialfilme. Die Bestimmung der Energielagen von HOMO und LUMO können dabei wie dem Fachmann bekannt z.B. über zyklische Voltametrie (CV) oder *Ultraviolett*-Photoelektronenspektroskopie (ultraviolet photon spectroscopie UPS) erfolgen.

Der Begriff "Transportenergieniveaulage" wird wie folgt definiert: Die Transportenergieniveaulage eines Transportschichtsystems ist die energetische Lage des HOMOs, falls es sich um ein p-Transportschichtsystem handelt, und ist die energetische Lage des LUMOs, falls es sich um ein n-Transportschichtsystem handelt.

Weiterhin wird der Begriff "energetisch angepasst" wie folgt definiert: Ein Transportschichtsystem, welches bevorzugt Elektronen leitet (n-Leiter), ist an ein photoaktives Schichtsystem energetisch angepasst, wenn das Energieniveau des LUMOs des Transportschichtsystems sich um weniger als 0,5eV von dem Energieniveau des LUMOs des Akzeptormaterials des photoaktiven Schichtsystems unterscheidet. Das Energieniveau des LUMOs des Transportschichtsystems kann sich dabei sowohl um maximal 0,5eV oberhalb des Energieniveau des LUMOs des Akzeptormaterials des photoaktiven Schichtsystems befinden als auch um maximal 0,5eV unterhalb. Falls mehrere Akzeptoren in dem photoaktiven Schichtsystem enthalten sind, so ist dasjenige Akzeptormaterial ausschlaggebend, welches über das energetisch tiefste LUMO verfügt. Bevorzugt können sich die Energieniveaulagen der LUMOs auch nur um 0,3eV unterscheiden, besonders bevorzugt auch nur um 0,2eV bzw. nur um 0,1eV oder sie können nahezu identisch sein.

Analog ist ein Transportschichtsystem, welches bevorzugt Löcher leitet (p-Leiter), an ein photoaktives Schichtsystem energetisch angepasst, wenn das Energieniveau des HOMOs des Transportschichtsystems sich um weniger als 0,5eV von dem Energieniveau des HOMOs des Donatormaterials des photoaktiven Schichtsystems unterscheidet. Das Energieniveau des HOMOs des Transportschichtsystems kann sich dabei sowohl um maximal 0,5eV oberhalb des Energieniveau des HOMOs des Donatormaterials des photoaktiven Schichtsystems befinden als auch um maximal 0,5eV unterhalb. Falls mehrere Donatoren in dem photoaktiven Schichtsystem enthalten sind, so ist dasjenige Donatormaterial ausschlaggebend, welches über das energetisch höchste HOMO verfügt. Bevorzugt können sich die Energieniveaulagen der HOMOs auch nur um 0,3eV unterscheiden, sehr bevorzugt auch nur um 0,2eV bzw. nur um 0,1eV oder nahezu oder exakt identisch sein.

Möglichkeiten zur Anpassung der LUMO-Niveaus bzw. der HOMO-Niveaus sind dem Fachmann bekannt, wobei sehr viele organische Materialien mit unterschiedlichen Lagen der Energieniveaus der HOMOs und LUMOs bekannt. Die Anpassung erfolgt daher derart, dass ein Material ausgewählt und verwendet wird, welches über die gewünschten Lage der Energieniveaus des HOMO bzw. LUMO verfügt. Weiterhin können z.B. durch den Einbau von elektronenziehenden bzw. elektronenschiebenden Gruppen die HOMO- und LUMO-Niveaus von organischen Materialien gesenkt bzw. erhöht werden und somit die Anpassung eines Materials entsprechend den Anforderungen erfolgen.

Im Rahmen dieser Anmeldung wird der Begriff "gut dotierbar" wie folgt definiert: Ein Löchertransportmaterial (p-Transportmaterial) bzw. ein Löchertransportschichtsystem (p-Transportschichtsystem) wird als gut dotierbar bezeichnet, wenn das Energieniveau seines HOMOs größer oder gleich - 5,5eV ist. Der Begriff "größer" (oder auch "höher") bezieht sich hier auf den zahlenmäßigen Wert, d.h. -5,4eV ist größer (höher) als -5,5eV. Bevorzugt liegt das Energieniveau des HOMOs im Bereich -5,2eV bis -4,9eV. Analog wird ein Elektronentransportmaterial (n-Transportmaterial) bzw. ein Elektronentransportschichtsystem (n-Transportschichtsystem) als gut dotierbar bezeichnet, wenn das Energieniveau des LUMOs kleiner oder gleich -3,0eV ist. Der Begriff "kleiner" (oder auch "tiefer") bezieht sich hier auf den zahlenmäßigen Wert, d.h. -3,1eV ist kleiner (tiefer) als -3,0eV. Bevorzugt liegt das Energieniveau des LUMOs im Bereich -3,5eV bis - 4,5eV.

Seit der Demonstration der ersten organischen Solarzelle mit einem Wirkungsgrad im Prozentbereich durch Tang et al. 1986 [C.W. Tang et al. Appl. Phys. Lett. 48, 183 (1986)], werden organische Materialien intensiv für verschiedene elektronische und optoelektronische Bauelemente untersucht. Organische Solarzellen bestehen aus einer Folge dünner Schichten (typischerweise 1nm bis 1µm) aus organischen Materialien, welche bevorzugt im Vakuum aufgedampft oder aus einer Lösung aufgeschleudert werden. Die elektrische Kontaktierung kann durch Metallschichten, transparente leitfähige Oxide (TCOs) und/oder transparente leitfähige Polymere (PEDOT-PSS, PANI) erfolgen.

Eine Solarzelle wandelt Lichtenergie in elektrische Energie um. Der Begriff photoaktiv bezeichnet hierbei ebenfalls die Umwandlung von Lichtenergie in elektrische Energie. Im Gegensatz zu anorganische Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in freie Ladungsträger getrennt, die dann zum elektrischen Stromfluß beitragen.

Der Vorteil solcher Bauelemente auf organischer Basis gegenüber den konventionellen Bauelementen auf anorganischer Basis (Halbleiter wie Silizium, Galliumarsenid) sind die teilweise extrem hohen optischen Absorptionskoeffizienten (bis zu 2x10⁵ cm⁻¹), so dass sich die Möglichkeit bietet, mit geringem Material- und Energieaufwand sehr dünne Solarzellen herzustellen. Weitere technologische Aspekte sind die niedrigen Kosten, die Möglichkeit, flexible großflächige Bauteile auf Plastikfolien herzustellen, und die nahezu unbegrenzten Variationsmöglichkeiten und die unbegrenzte Verfügbarkeit der organischen Chemie.

Eine in der Literatur bereits vorgeschlagene Realisierungsmöglichkeit einer organischen Solarzelle besteht in einer pin -Diode [Martin Pfeiffer, "Controlled doping of organic vacuum deposited dye layers: basics and applications", PhD thesis TU-Dresden, 1999.] mit folgendem Schichtaufbau:
0. Träger, Substrat,
1. Grundkontakt, meist transparent,
2. p- Schicht(en),
3. i- Schicht(en),
4. n- Schicht(en),
5. Deckkontakt.

Hierbei bedeutet n bzw. p eine n- bzw. p-Dotierung, die zu einer Erhöhung der Dichte freier Elektronen bzw. Löcher im thermischen Gleichgewichtszustand führt. Es ist allerdings auch möglich, dass die n-Schicht(en) bzw. p-Schicht(en) zumindest teilweise nominell undotiert sind und nur aufgrund der Materialeigenschaften (z.B. unterschiedliche Beweglichkeiten), aufgrund unbekannter Verunreinigungen (z.B. verbliebene Reste aus der Synthese, Zerfalls-oder Reaktionsprodukte während der Schichtherstellung) oder aufgrund von Einflüssen der Umgebung (z.B. angrenzende Schichten, Eindiffusion von Metallen oder anderen organischen Materialien, Gasdotierung aus der Umgebungsatmosphäre) bevorzugt n-leitende bzw. bevorzugt p-leitende Eigenschaften besitzen. In diesem Sinne sind derartigen Schichten primär als Transportschichten zu verstehen. Die Bezeichnung i-Schicht bezeichnet demgegenüber eine nominell undotierte Schicht (intrinsische Schicht). Eine oder mehrere i-Schichten können hierbei Schichten sowohl aus einem Material, als auch eine Mischung aus zwei Materialien (sogenannte interpenetrierende Netzwerke bzw. bulk-heterojunction; M. Hiramoto et al. Mol. Cryst. Liq. Cryst., 2006, 444, pp. 33-40) bestehen. Das durch den transparenten Grundkontakt einfallende Licht erzeugt in der i-Schicht bzw. in der n-/p-Schicht Exzitonen (gebundene Elektron-Loch-Paare). Diese Exzitonen können nur durch sehr hohe elektrische Felder oder an geeigneten Grenzflächen getrennt werden. In Organische Solarzellen stehen ausreichend hohe Felder nicht zur Verfügung, so dass alle Erfolg versprechenden Konzepte für organische Solarzellen auf der Exzitonentrennung an photoaktiven Grenzflächen beruhen. Die Exzitonen gelangen durch Diffusion an eine derartige aktive Grenzfläche, wo Elektronen und Löcher voneinander getrennt werden. Das Material, welches die Elektronen aufnimmt, wird dabei als Akzeptor, und das Material, welches das Loch aufnimmt, als Donator (oder Donor) bezeichnet. Die trennende Grenzfläche kann zwischen der p- (n-) Schicht und der i-Schicht bzw. zwischen zwei i-Schichten liegen. Im eingebauten elektrischen Feld der Solarzelle werden die Elektronen nun zum n-Gebiet und die Löcher zum p-Gebiet abtransportiert. Vorzugsweise handelt es sich bei den Transportschichten um transparente oder weitgehend transparente Materialien mit großer Bandlücke (wide-gap) wie sie z.B. in WO 2004083958 beschrieben sind. Als wide-gap Materialien werden hierbei Materialien bezeichnet, deren Absorptionsmaximum im Wellenlängenbereich <450nm liegt, vorzugsweise bei <400nm.

Da durch das Licht immer erst Exzitonen erzeugt werden und noch keine freien Ladungsträger, spielt die rekombinationsarme Diffusion von Exzitonen an die aktive Grenzfläche eine kritische Rolle bei Organische Solarzellen. Um einen Beitrag zum Photostrom zu leisten, muss daher in einer guten organischen Solarzelle die Exzitonendiffusionslänge die typische Eindringtiefe des Lichts deutlich übersteigen, damit der überwiegende Teil des Lichts genutzt werden kann. Strukturell und bezüglich der chemischen Reinheit perfekte organische Kristalle oder Dünnschichten erfüllen durchaus dieses Kriterium. Für großflächige Anwendungen ist allerdings die Verwendung von monokristallinen organischen Materialien nicht möglich und die Herstellung von Mehrfachschichten mit ausreichender struktureller Perfektion ist bis jetzt noch sehr schwierig.

Falls es sich bei der i-Schicht um eine Mischschicht handelt, so übernimmt die Aufgabe der Lichtabsorption entweder nur eine der Komponenten oder auch beide. Der Vorteil von Mischschichten ist, dass die erzeugten Exzitonen nur einen sehr kurzen Weg zurücklegen müssen bis sie an eine Domänengrenze gelangen, wo sie getrennt werden. Der Abtransport der Elektronen bzw. Löcher erfolgt getrennt in den jeweiligen Materialien. Da in der Mischschicht die Materialien überall miteinander im Kontakt sind, ist bei diesem Konzept entscheidend, dass die getrennten Ladungen eine lange Lebensdauer auf dem jeweiligen Material besitzen und von jedem Ort aus geschlossene Perkolationspfade für beide Ladungsträgersorten zum jeweiligen Kontakt hin vorhanden sind.

Aus der US 5,093,698 ist die Dotierung organischer Materialien bekannt. Durch Beimischung einer akzeptorartigen bzw. donatorartigen Dotiersubstanz wird die Gleichgewichtsladungsträgerkonzentration in der Schicht erhöht und die Leitfähigkeit gesteigert. Nach US 5,093,698 werden die dotierten Schichten als Injektionsschichten an der Grenzfläche zu den Kontaktmaterialien in elektrolumineszierenden Bauelementen verwendet. Ähnliche Dotierungsansätze sind analog auch für Solarzellen zweckmäßig.

Aus der Literatur sind verschiedene Realisierungsmöglichkeiten für die photoaktive i-Schicht bekannt. So kann es sich hierbei um eine Doppelschicht (EP0000829) oder eine Mischschicht (Hiramoto, Appl. Phys.Lett. 58,1062 (1991)) handeln. Bekannt ist auch eine Kombination aus Doppel-und Mischschichten (Hiramoto, Appl. Phys.Lett. 58,1062 (1991); US 6,559,375). Ebenfalls bekannt ist, dass das Mischungsverhältnis in verschiedenen Bereichen der Mischschicht unterschiedlich ist (US 20050110005) bzw. das Mischungsverhältnis einen Gradienten aufweist.

Weiterhin sind der Aufbau und die Funktion von Tandem- bzw. Mehrfachsolarzellen aus der Literatur bekannt (Hiramoto, Chem. Lett.,1990, 327 (1990); DE 102004014046). Speziell ist auch der Aufbau und die Funktion des Rekombinationsbereiches in den Tandemzellen in der DE 102004014046 beschrieben.

Weiterhin aus der Literatur bekannt sind organische pin-Tandemzellen (DE 102004014046): Die Struktur solch einer Tandemzelle besteht aus zwei pin-Einzelzellen, wobei die Schichtfolge "pin" die Abfolge aus einem p-dotierten Schichtsystem, einem undotierten photoaktiven Schichtsystem und einem n-dotierten Schichtsystem beschreibt. Die dotierten Schichtsysteme bestehen bevorzugt aus transparenten Materialien, so genannten wide-gap Materialien/Schichten und sie können hierbei auch teilweise oder ganz undotiert sein oder auch ortsabhängig verschiedene Dotierungskonzentrationen aufweisen bzw. über einen kontinuierlichen Gradienten in der Dotierungskonzentration verfügen. Speziell auch sehr gering dotierte oder hochdotierte Bereiche im Grenzbereich an den Elektroden, im Grenzbereich zu einer anderen dotierten oder undotierten Transportschicht, im Grenzbereich zu den aktiven Schichten oder bei Tandem- oder Mehrfachzellen im Grenzbereich zu der anliegenden pin- bzw. nip- Teilzelle, d.h. im Bereich der Rekombinationszone sind möglich. Auch eine beliebige Kombination aus allen diesen Merkmalen ist möglich. Natürlich kann es sich bei einer solchen Tandemzelle auch um eine sogenannte invertierte Struktur (z.B. nip-Tandemzelle; handeln. Im Folgenden werden alle diese möglichen Tandemzellen-Realisierungsformen mit dem Begriff pin-Tandemzellen bezeichnet.

Unter kleinen Molekülen werden im Sinne der vorliegenden Erfindung nicht-polymere organische Moleküle mit monodispersen Molmassen zwischen 100 und 2000 verstanden, die unter Normaldruck (Luftdruck der uns umgebenden Atmosphäre) und bei Raumtemperatur in fester Phase vorliegen. Insbesondere können diese kleinen Molekülen auch photoaktiv sein, wobei unter photoaktiv verstanden wird, dass die Moleküle unter Lichteinfall ihren Ladungszustand ändern.

Das Problem von organischen Solarzellen ist derzeit, dass selbst die höchsten bisher im Labor erreichten Wirkungsgrade von 7-8% noch zu gering sind. Für die meisten Anwendungen, speziell großflächige Anwendungen, wird ein Wirkungsgrad von ca. 10% als notwendig erachtet. Aufgrund der schlechteren Transporteigenschaften von organischen Halbleitern (im Vergleich zu anorganischen Halbleitern) und der damit verbundenen limitierten einsetzbaren Schichtdicken der Absorber in organischen Solarzellen geht man generell davon aus, dass solche Wirkungsgrade am ehesten mit Hilfe von Tandemzellen realisiert werden können (Tayebeh Ameri et al. ,Organic tandem solar cells: A review, Energy Environ. Sci., 2009, 2, 347-363; DE 10 2004 014 046.4). Speziell Wirkungsgrade bis zu 15% werden in Zukunft wohl nur mit Hilfe von Tandemzellen möglich sein.

Der Nachteil der bisher bekannten Tandemzellen liegt darin, dass zwischen zwei photoaktiven Schichtsystemen (im folgenden auch als Absorbersysteme oder Absorberschichtsysteme bezeichnet) nur ein Transportschichtsystem eines Ladungsträgertyps verwendet wird. Der Nachteil hieran liegt darin, dass dieses eine Transportschichtsystem sowohl energetisch gut an ein Absorbersystem angepasst sein muss (um eine effiziente Extraktion der Ladungsträger aus dem Absorbersystem zu ermöglichen und z.B. keine Energiebarriere für die Ladungsträger zu bilden) und andrerseits möglichst gut transparent sein soll (um keine parasitäre Absorption zu bilden) und möglichst gute Ladungsträger-Transporteigenschaften aufweisen soll. Die bisher bekannten Materialien erfüllen meist nur eine dieser Eigenschaften wirklich zufriedenstellend und oft wird ein Kompromissmaterial verwendet, das beide Eigenschaften einigermaßen gut bis befriedigend erfüllt. Falls aus optischen Gründen ein dickes Transportschichtsystem benötigt wird, besteht zusätzlich oft das Problem, dass das verwendete Material nicht über eine ausreichende Leitfähigkeit verfügt und somit das Bauelement aufgrund des gebildeten Serienwiderstandes in seinen Eigenschaften (Effizienz, Füllfaktor, Spannung) begrenzt wird. Teilweise wird dieses Problem dadurch zu lösen versucht, dass eine höhere Dotierungskonzentration gewählt wird. Diese Lösungsversuche haben aber nur einen begrenzten Erfolg und durch den höheren Einsatz an Dotandenmaterialien wird der Produktionsprozess der Bauelemente verteuert, was einer kommerziellen Verwertung im Wege steht.

[(Schueppel, R. et. a.l. :J. Appl.Phys. 107 (2010), 44503)] beschreibt eine organische Tandemphotovoltaikzelle, die zwischen den photoaktiven Schichtsystemen zwei verschiedene Transportsysteme des gleichen Ladungsträgers aufweist. Die Transportsysteme bestehen aus den gleichen Materialien, unterscheiden sich nur in der Dotierungskonzentration der Dotanden. Damit lassen sich die Eigenschaften bezüglich energetische Anpassung, Transporteigenschaften und/oder Transparenz in den Transportschichtsystemen nicht beeinflussen.

[Uhrich, Chr. et al.: J. Appl. Phys. 104 (2008) 43107] beschreibt ebenfalls nur Transportsysteme aus identischen Materialien.

[Yook et al.: Adv. Funct. Mater. 20 (2010), 1797.] offenbart eine TandemOLED, wobei sich zwischen den beiden photoaktiven Schichtsystemen ein Schichtstapel aus undotierten Bphen, mit CsN₃ dotierten Bphen und MoO₃ befindet.

Die Verwendung von zwei verschiedenen Transportschichtsystemen anstelle des bisher verwendeten einen Transportschichtsystems ist von großer technischer Bedeutung. Der gesamte Transportschichtbereich zwischen den photoaktiven Schichtsystemen, muss mehrere Funktionen erfüllen, nämlich eine gute bis möglichst nahezu perfekte energetische Anpassung erreichen, möglichst sehr gute Transporteigenschaften aufweisen, möglichst vollständig transparent sein und darüber hinaus auch thermisch und mechanisch stabil sein. Alle diese Eigenschaften in nur einem Material für einen Ladungsträgertyp perfekt zu vereinen, ist nahezu unmöglich. Beim bisherigen Stand der Entwicklung von organischen Solarzellen ist dieses Problem noch nicht offensichtlich klar geworden, da die bisherigen Solarzellen mit einem Wirkungsgrad von 6-8% auch mit einem Material realisiert werden konnten, dass nicht alle Eigenschaften gut bis sehr gut erfüllt. Für die kommerzielle Verwertung sind aber Wirkungsgrade von 10-12% und darüberhinaus absolut notwendig. Um diese hohen Wirkungsgrade zu erreichen, müssen alle Verlustmechanismen innerhalb der Solarzellenstruktur beseitigt werden. Ein glanz wichtiger Baustein hierfür ist dass der Transportschichtbereich zwischen den photoaktiven Schichtsystemen in Tandem- oder Mehrfachzellen die gestellten Anforderungen nahezu perfekt erfüllt. Dies ist wie oben erläutert praktisch und technisch nur erreichbar, wenn mindestens zwei verschiedene Transportschichtsysteme gleichen Ladungsträgertyps verwendet werden.

Die Aufgabe der vorliegenden Erfindung besteht daher darin, ein organisches photoaktives Bauelement anzugeben, welches die aufgezeigten Nachteile überwindet.

Erfindungsgemäß wird diese Aufgabe durch ein organisches photoaktives Bauelement gemäß dem Hauptanspruch gelöst. Vorteilhafte Ausgestaltungen sind in den abhängigen Ansprüchen angegeben.

Das erfindungsgemäße Bauelement, welches als Tandem- oder Mehrfachzelle ausgeführt ist, weist eine Elektrode und eine Gegenelektrode auf und zwischen den Elektroden zumindest ein organisches Schichtsystem und weiterhin mindestens zwei photoaktive Schichtsysteme und zwischen den photoaktiven Schichtsystemen zumindest zwei verschiedene Transportschichtsysteme des gleichen Ladungsträgertyps, wobei das eine Transportschichtsystem energetisch an eines der beiden photoaktiven Schichtsysteme angepasst ist und dass das andere Transportschichtsystem transparent ausgeführt ist.

Ein Transportschichtsystem, welches bevorzugt Elektronen leitet (n-Leiter), ist an ein photoaktives Schichtsystem energetisch angepasst, wenn das Energieniveau des LUMOs des Transportschichtsystems sich um weniger als 0,5eV von dem Energieniveau des LUMOs des Akzeptormaterials des photoaktiven Schichtsystems unterscheidet. Das Energieniveau des LUMOs des Transportschichtsystems kann sich dabei sowohl um maximal 0,5eV oberhalb des Energieniveau des LUMOs des Akzeptormaterials des photoaktiven Schichtsystems befinden als auch um maximal 0,5eV unterhalb. Falls mehrere Akzeptoren in dem photoaktiven Schichtsystem enthalten sind, so ist dasjenige Akzeptormaterial ausschlaggebend, welches über das energetisch tiefste LUMO verfügt. Bevorzugt können sich die Energieniveaulagen der LUMOs auch nur um 0,3eV unterscheiden, besonders bevorzugt auch nur um 0,2eV bzw. nur um 0,1eV oder sie können nahezu identisch sein.

Analog ist ein Transportschichtsystem, welches bevorzugt Löcher leitet (p-Leiter), an ein photoaktives Schichtsystem energetisch angepasst, wenn das Energieniveau des HOMOs des Transportschichtsystems sich um weniger als 0,5eV von dem Energieniveau des HOMOs des Donatormaterials des photoaktiven Schichtsystems unterscheidet. Das Energieniveau des HOMOs des Transportschichtsystems kann sich dabei sowohl um maximal 0,5eV oberhalb des Energieniveau des HOMOs des Donatormaterials des photoaktiven Schichtsystems befinden als auch um maximal 0,5eV unterhalb. Falls mehrere Donatoren in dem photoaktiven Schichtsystem enthalten sind, so ist dasjenige Donatormaterial ausschlaggebend, welches über das energetisch höchste HOMO verfügt. Bevorzugt können sich die Energieniveaulagen der HOMOs auch nur um 0,3eV unterscheiden, sehr bevorzugt auch nur um 0,2eV bzw. nur um 0,1eV oder nahezu oder exakt identisch sein.

In einer Ausführungsform der Erfindung weist das transparente Transportschichtsystem eine Leitfähigkeit >= 1*10⁻⁶ S/cm auf und/oder ist dotiert.

In einer Ausführungsform der Erfindung grenzen beide Transportschichtsysteme direkt aneinander und/oder beide sind transparent.

In einer Ausführungsform der Erfindung besteht eins oder bestehen beide Transportschichtsysteme aus zumindest einem organischen Material. Vorzugsweise bestehen die Transportschichtsysteme aus organischen Materialien.

In einer Ausführungsform der Erfindung hat eins oder haben beide Transportschichtsysteme eine hohe intrinsische Beweglichkeit der Ladungsträger. Der Begriff intrinsisch bedeutet hierbei nominell undotiert, d.h. die intrinsische Beweglichkeit der Ladungsträger eines Materials ist diejenige Beweglichkeit, wenn das Material undotiert ist.

In einer Ausführungsform der Erfindung liegen die Transportenergieniveaulagen (HOMO bzw. LUMO) des transparenten Transportschichtsystems so, dass es gut dotiert werden kann.

In einer Ausführungsform der Erfindung ist das Energieniveau des LUMOs eines n-Transportschichtsystems (n-Leiter) nahezu oder exakt identisch wie das Energieniveau des LUMOs des Akzeptormaterials des photoaktiven Schichtsystems. Diese spezielle Ausführung hat den Vorteil, dass die Elektronen barrierefrei das photoaktive Schichtsystem verlassen können und kein Verlust in der Leerlaufspannung des Bauelementes auftritt.

In einer Ausführungsform der Erfindung ist das Energieniveau des LUMOs eines n-Transportschichtsystems (n-Leiter) um maximal 0,5eV, bevorzugt maximal 0,3eV, sehr bevorzugt maximal 0,2eV oder 0,1eV oder 0,05eV tiefer als das Energieniveau des LUMOs des Akzeptormaterials des photoaktiven Schichtsystems. Diese spezielle Ausführung hat den Vorteil, dass die Elektronen energetisch bevorzugt in das tiefere LUMO des n-Transportschichtsystems gelangen und somit die Elektronen effizient abtransportiert werden. In einer Ausführungsform der Erfindung ist das Energieniveau des LUMOs eines n-Transportschichtsystems (n-Leiter) um maximal 0,5eV, bevorzugt maximal 0,3eV, sehr bevorzugt maximal 0,2eV oder 0,1eV oder 0,05eV höher als das Energieniveau des LUMOs des Akzeptormaterials des photoaktiven Schichtsystems. Diese spezielle Ausführung hat den Vorteil, dass durch das höhere LUMO des n-Transportschichtsystems das eingebaute Feld innerhalb der Solarzelle größer ist und die Elektronen somit effizient abtransportiert werden.

In einer Ausführungsform der Erfindung ist das Energieniveau des HOMOs eines p-Transportschichtsystems (p-Leiter) nahezu oder exakt identisch wie das Energieniveau des HOMOs des Donatormaterials des photoaktiven Schichtsystems. Diese spezielle Ausführung hat den Vorteil, dass die Löcher barrierefrei das photoaktive Schichtsystem verlassen können und kein Verlust in der Leerlaufspannung des Bauelementes auftritt.

In einer Ausführungsform der Erfindung ist das Energieniveau des HOMOs eines p-Transportschichtsystems (p-Leiter) um maximal 0,5eV, bevorzugt maximal 0,3eV, sehr bevorzugt maximal 0,2eV oder 0,1eV oder 0,05eV tiefer als das Energieniveau des HOMOs des Donatormaterials des photoaktiven Schichtsystems. Diese spezielle Ausführung hat den Vorteil, dass durch das tiefere HOMO des p-Transportschichtsystems das eingebaute Feld innerhalb der Solarzelle größer ist und die Löcher somit effizient abtransportiert werden.

In einer Ausführungsform der Erfindung ist das Energieniveau des HOMOs eines p-Transportschichtsystems (p-Leiter) um maximal 0,5eV, bevorzugt maximal 0,3eV, sehr bevorzugt maximal 0,2eV oder 0,1eV oder 0,05eV höher als das Energieniveau des HOMOs des Donatormaterials des photoaktiven Schichtsystems. Diese spezielle Ausführung hat den Vorteil, dass die Löcher energetisch bevorzugt in das höhere HOMO des p-Transportschichtsystems gelangen und somit die Löcher effizient abtransportiert werden.

In einer Ausführungsform der Erfindung ist eine oder sind beide Transportschichtsysteme Einzelschichten oder Mischschichten, wobei diese undotiert oder teilweise dotiert oder komplett dotiert sind und die Dotierung einen Gradienten aufweist und/oder die Dotierung innerhalb der Schicht verschiedene Konzentrationen aufweist. In einer Ausführungsform der Erfindung sind die beiden Transportschichtsysteme mit verschiedenen Dotanden dotiert.

In einer Ausführungsform der Erfindung ist zwischen den photoaktiven Schichtsystemen noch ein weiteres Transportschichtsystem des anderen Ladungsträgertyps vorhanden.

In einer Ausführungsform der Erfindung sind zwischen den photoaktiven Schichtsystemen noch zwei weitere Transportschichtsysteme des anderen Ladungsträgertyps vorhanden, wobei das eine Transportschichtsystem energetisch an das andere (im Vergleich zum Transportschichtsystem) photoaktiven Schichtsysteme angepasst ist und das zweite Transportschichtsystem transparent ist.

In einer Ausführungsform der Erfindung ist eine oder sind beide der weiteren Transportschichtsysteme als Einzel- oder Mischschichten ausgeführt. Weiterhin können die Transportschichtsysteme undotiert, teilweise dotiert oder komplett dotiert sein, wobei die Dotierung einen Gradienten aufweist oder die Dotierung variiert räumlich, und/oder die Transportschichtsysteme mit verschiedenen Dotanden dotiert sind.

In einer Ausführungsform der Erfindung sind zwischen den photoaktiven Schichtsystemen noch eine oder mehrere weitere undotierte, teilweise dotierte oder komplett dotierte Schichten bzw. Mischschichten aus anorganischen Materialien, organischen Materialien, kleinen Molekülen, Polymeren, Metallen, Metalloxiden, Salzen oder einem leitfähigen Oxid vorhanden.

In einer Ausführungsform der Erfindung sind in zumindest zwei photoaktiven Schichtsystemen verschiedene Materialien vorhanden. Bevorzugt absorbieren die photoaktiven Schichtsysteme in verschiedenen Wellenlängenbereichen des Sonnenspektrums.

In einer Ausführungsform der Erfindung sind zwischen dem photoaktiven Schichtsystem und der Elektrode und/oder zwischen dem photoaktiven Schichtsystem und der Gegenelektrode mindestens zwei Transportschichtsysteme vorhanden, wobei das eine Transportschichtsystem energetisch an das jeweilige photoaktive Schichtsystem angepasst ist, wobei das zweite Transportschichtsystem transparent ausgeführt ist.

In einer Ausführungsform der Erfindung sind zwischen dem photoaktiven Schichtsystem und der Elektrode und/oder zwischen dem photoaktiven Schichtsystem und der Gegenelektrode mindestens drei Transportschichtsysteme vorhanden, wobei das eine Transportschichtsystem energetisch an das jeweilige photoaktive Schichtsystem angepasst ist, das zweite Transportschichtsystem transparent ist und das dritte Transportschichtsystem energetisch an die Elektrode bzw. Gegenelektrode angepasst ist.

In einer Ausführungsform der Erfindung sind die im Bauelement vorhandenen Transportschichtsysteme unabhängig voneinander als Einzelschichten oder Mischschichten oder aus Nanoclustern bestehend ausgeführt. Weiterhin sind die Transportschichtsysteme transparent oder semitransparent ausgeführt. Dabei können diese undotiert, teilweise dotiert oder komplett dotiert sein, wobei die Dotierung einen Gradienten aufweisen oder die Dotierung räumlich variieren kann. Weiterhin können die Transportschichtsysteme an den Elektroden oder in einem Bereich bis zu 30nm entfernt von den Elektroden höher dotiert sein und/oder die Transportschichtsysteme können mit verschiedenen Dotanden dotiert sein.

In einer weiteren Ausführungsform der Erfindung besteht das Bauelement aus einer Tandem- oder Mehrfachzelle. Bevorzugt besteht das Bauelement aus einer Kombination aus nip, ni, ip, pnip, pni, pip, nipn, nin, ipn, pnipn, pnin oder pipn-Strukturen, bei der mehrere unabhängige Kombinationen, die mindestens eine i-Schicht enthalten, übereinander gestapelt sind.

In weiteren Ausführungsformen der Erfindung kann das Bauelement folgende Schichtreihenfolgen aufweisen, worin p= p-Transportschichtsystem bedeutet, n=n-Transportschichtsystem bedeutet und i=photoaktives Schichtsystem bedeutet:
Elektrode / pinnin / Gegenelektrode
Elektrode / nippip / Gegenelektrode
Elektrode / pinnpin / Gegenelektrode
Elektrode / nippnip / Gegenelektrode
Elektrode / pinppin / Gegenelektrode
Elektrode / nipnnip / Gegenelektrode
Elektrode / pinnppin / Gegenelektrode
Elektrode / nippnnip / Gegenelektrode
Elektrode / pinnnin / Gegenelektrode
Elektrode / nipppip / Gegenelektrode
Elektrode / pinnnpin / Gegenelektrode
Elektrode / nipppnip / Gegenelektrode
Elektrode / pinpppin / Gegenelektrode
Elektrode / nipnnnip / Gegenelektrode
Elektrode / pinnnppin / Gegenelektrode
Elektrode / nipppnnip / Gegenelektrode
Elektrode / pinnpppin / Gegenelektrode
Elektrode / nippnnnip / Gegenelektrode
Elektrode / pinnnpppin / Gegenelektrode
Elektrode / nipppnnnip / Gegenelektrode
Elektrode / pinnnnin / Gegenelektrode
Elektrode / nippppip / Gegenelektrode
Elektrode / pinnnnpin / Gegenelektrode
Elektrode / nippppnip / Gegenelektrode
Elektrode / pinppppin / Gegenelektrode
Elektrode / nipnnnnip / Gegenelektrode
Elektrode / pinnnnppin / Gegenelektrode
Elektrode / nippppnnip / Gegenelektrode
Elektrode / pinnppppin / Gegenelektrode
Elektrode / nippnnnnip / Gegenelektrode
Elektrode / pinnnnpppin / Gegenelektrode
Elektrode / nippppnhnip / Gegenelektrode
Elektrode / pinnnppppin / Gegenelektrode
Elektrode / nipppnnnnip / Gegenelektrode
Elektrode / pinnnnppppin / Gegenelektrode
Elektrode / nippppnnnnip / Gegenelektrode

Natürlich können auch 5,6 oder mehr Transportschichtsysteme gleichen Ladungsträgertyps hintereinander vorhanden sein. In weiteren Ausführungsformen der Erfindung kann das Bauelement weiterhin folgende Schichtreihenfolgen aufweisen:
Elektrode / ppinnin / Gegenelektrode
Elektrode / nnippip / Gegenelektrode
Elektrode / ppinnpin / Gegenelektrode
Elektrode / nnippnip / Gegenelektrode
Elektrode / ppinppin / Gegenelektrode
Elektrode / nnipnnip / Gegenelektrode
Elektrode / ppinnppin / Gegenelektrode
Elektrode / nnippnnip / Gegenelektrode
Elektrode / ppinnnin / Gegenelektrode
Elektrode / nnipppip / Gegenelektrode
Elektrode / ppinnnpin / Gegenelektrode
Elektrode / nnipppnip / Gegenelektrode
Elektrode / ppinpppin / Gegenelektrode
Elektrode / nnipnnnip / Gegenelektrode
Elektrode / ppinnnppin / Gegenelektrode
Elektrode / nnipppnnip / Gegenelektrode
Elektrode / ppinnpppin / Gegenelektrode
Elektrode / nnippnnnip / Gegenelektrode
Elektrode / ppinnnpppin / Gegenelektrode
Elektrode / nnipppnnnip / Gegenelektrode
Elektrode / ppinnnnin / Gegenelektrode
Elektrode / nnippppip / Gegenelektrode
Elektrode / ppinnnnpin / Gegenelektrode
Elektrode / nnippppnip / Gegenelektrode
Elektrode / ppinppppin / Gegenelektrode
Elektrode / nnipnnnnip / Gegenelektrode
Elektrode / ppinnnnppin / Gegenelektrode
Elektrode / nnippppnnip / Gegenelektrode
Elektrode / ppinnppppin / Gegenelektrode
Elektrode / nnippnnnnip / Gegenelektrode
Elektrode / ppinnnnpppin / Gegenelektrode
Elektrode / nnippppnnnip / Gegenelektrode
Elektrode / ppinnnppppin / Gegenelektrode
Elektrode / nnipppnnnnip / Gegenelektrode
Elektrode / ppinnnnppppin / Gegenelektrode
Elektrode / nnippppnnnnip / Gegenelektrode
Elektrode / pinninn / Gegenelektrode
Elektrode / nippipp / Gegenelektrode
Elektrode / pinnpinn / Gegenelektrode
Elektrode / nippnipp / Gegenelektrode
Elektrode / pinppinn / Gegenelektrode
Elektrode / nipnnipp / Gegenelektrode
Elektrode / pinnppinn / Gegenelektrode
Elektrode / nippnnipp / Gegenelektrode
Elektrode / pinnninn / Gegenelektrode
Elektrode / nipppipp / Gegenelektrode
Elektrode / pinnnpinn / Gegenelektrode
Elektrode / nipppnipp / Gegenelektrode
Elektrode / pinpppinn / Gegenelektrode
Elektrode / nipnnnipp / Gegenelektrode
Elektrode / pinnnppinn / Gegenelektrode
Elektrode / nipppnnipp / Gegenelektrode
Elektrode / pinnpppinn / Gegenelektrode
Elektrode / nippnnnipp / Gegenelektrode
Elektrode / pinnnpppinn / Gegenelektrode
Elektrode / nipppnnnipp / Gegenelektrode
Elektrode / pinnnninn / Gegenelektrode
Elektrode / nippppipp / Gegenelektrode
Elektrode / pinnnnpinn / Gegenelektrode
Elektrode / nippppnipp / Gegenelektrode
Elektrode / pinppppinn / Gegenelektrode
Elektrode / nipnnnnipp / Gegenelektrode
Elektrode / pinnnnppinn / Gegenelektrode
Elektrode / nippppnnipp / Gegenelektrode
Elektrode / pinnppppinn / Gegenelektrode
Elektrode / nippnnnnipp / Gegenelektrode
Elektrode / pinnnnpppinn / Gegenelektrode
Elektrode / nippppnnnipp / Gegenelektrode
Elektrode / pinnnppppinn / Gegenelektrode
Elektrode / nipppnnnnipp / Gegenelektrode
Elektrode / pinnnnppppinn / Gegenelektrode
Elektrode / nippppnnnnipp / Gegenelektrode

Elektrode / pppinnin / Gegenelektrode
Elektrode / nnnippip / Gegenelektrode
Elektrode / pppinnpin / Gegenelektrode
Elektrode / nnnippnip / Gegenelektrode
Elektrode / pppinppin / Gegenelektrode
Elektrode / nnnipnnip / Gegenelektrode
Elektrode / pppinnppin / Gegenelektrode
Elektrode / nnnippnnip / Gegenelektrode
Elektrode / pppinnnin / Gegenelektrode
Elektrode / nnnipppip / Gegenelektrode
Elektrode / pppinnnpin / Gegenelektrode
Elektrode / nnnipppnip / Gegenelektrode
Elektrode / pppinpppin / Gegenelektrode
Elektrode / nnnipnnnip / Gegenelektrode
Elektrode / pppinnnppin / Gegenelektrode
Elektrode / nnnipppnnip / Gegenelektrode
Elektrode / pppinnpppin / Gegenelektrode
Elektrode / nnnippnnnip / Gegenelektrode
Elektrode / pppinnnpppin / Gegenelektrode
Elektrode / nnnipppnnnip / Gegenelektrode
Elektrode / pppinnnnin / Gegenelektrode
Elektrode / nnnippppip / Gegenelektrode
Elektrode / pppinnnnpin / Gegenelektrode
Elektrode / nnnippppnip / Gegenelektrode
Elektrode / pppinppppin / Gegenelektrode
Elektrode / nnnipnnnnip / Gegenelektrode
Elektrode / pppinnnnppin / Gegenelektrode
Elektrode / nnnippppnnip / Gegenelektrode
Elektrode / pppinnppppin / Gegenelektrode
Elektrode / nnnippnnnnip / Gegenelektrode
Elektrode / pppinnnnpppin / Gegenelektrode
Elektrode / nnnippppnnnip / Gegenelektrode
Elektrode / pppinnnppppin / Gegenelektrode
Elektrode / nnnipppnnnnip / Gegenelektrode
Elektrode / pppinnnnppppin / Gegenelektrode
Elektrode / nnnippppnnnnip / Gegenelektrode

Elektrode / pinninnn / Gegenelektrode
Elektrode / nippippp / Gegenelektrode
Elektrode / pinnpinnn / Gegenelektrode
Elektrode / nippnippp / Gegenelektrode
Elektrode / pinppinnn / Gegenelektrode
Elektrode / nipnnippp / Gegenelektrode
Elektrode / pinnppinnn / Gegenelektrode
Elektrode / nippnnippp / Gegenelektrode
Elektrode / pinnninnn / Gegenelektrode
Elektrode / nipppippp / Gegenelektrode
Elektrode / pinnnpinnn / Gegenelektrode
Elektrode / nipppnippp / Gegenelektrode
Elektrode / pinpppinnn / Gegenelektrode
Elektrode / nipnnnippp / Gegenelektrode
Elektrode / pinnnppinnn / Gegenelektrode
Elektrode / nipppnnippp / Gegenelektrode
Elektrode / pinnpppinnn / Gegenelektrode
Elektrode / nippnnnippp / Gegenelektrode
Elektrode / pinnnpppinnn / Gegenelektrode
Elektrode / nipppnnnippp / Gegenelektrode
Elektrode / pinnnninnn / Gegenelektrode
Elektrode / nippppippp / Gegenelektrode
Elektrode / pinnnnpinnn / Gegenelektrode
Elektrode / nippppnippp / Gegenelektrode
Elektrode / pinppppinnn / Gegenelektrode
Elektrode / nipnnnnippp / Gegenelektrode
Elektrode / pinnnnppinnn / Gegenelektrode
Elektrode / nippppnnippp / Gegenelektrode
Elektrode / pinnppppinnn / Gegenelektrode
Elektrode / nippnnnnippp / Gegenelektrode
Elektrode / pinnnnpppinnn / Gegenelektrode
Elektrode / nippppnnnippp / Gegenelektrode
Elektrode / pinnnppppinnn / Gegenelektrode
Elektrode / nipppnnnnippp / Gegenelektrode
Elektrode / pinnnnppppinnn / Gegenelektrode
Elektrode / nippppnnnnippp / Gegenelektrode

Elektrode / ppppinnin / Gegenelektrode
Elektrode / nnnnippip / Gegenelektrode
Elektrode / ppppinnpin / Gegenelektrode
Elektrode / nnnnippnip / Gegenelektrode
Elektrode / ppppinppin / Gegenelektrode
Elektrode / nnnnipnnip / Gegenelektrode
Elektrode / ppppinnppin / Gegenelektrode
Elektrode / nnnnippnnip / Gegenelektrode
Elektrode / ppppinnnin / Gegenelektrode
Elektrode / nnnnipppip / Gegenelektrode
Elektrode / ppppinnnpin / Gegenelektrode
Elektrode / nnnnipppnip / Gegenelektrode
Elektrode / ppppinpppin / Gegenelektrode
Elektrode / nnnnipnnnip / Gegenelektrode
Elektrode / ppppinnnppin / Gegenelektrode
Elektrode / nnnnipppnnip / Gegenelektrode
Elektrode / ppppinnpppin / Gegenelektrode
Elektrode / nnnnippnnnip / Gegenelektrode
Elektrode / ppppinnnpppin / Gegenelektrode
Elektrode / nnnnipppnnnip / Gegenelektrode
Elektrode / ppppinnnnin / Gegenelektrode
Elektrode / nnnnippppip / Gegenelektrode
Elektrode / ppppinnnnpin / Gegenelektrode
Elektrode / nnnnippppnip / Gegenelektrode
Elektrode / ppppinppppin / Gegenelektrode
Elektrode / nnnnipnnnnip / Gegenelektrode
Elektrode / ppppinnnnppin / Gegenelektrode
Elektrode / nnnnippppnnip / Gegenelektrode
Elektrode / ppppinnppppin / Gegenelektrode
Elektrode / nnnnippnnnnip / Gegenelektrode
Elektrode / ppppinnnnpppin / Gegenelektrode
Elektrode / nnnnippppnnnip / Gegenelektrode
Elektrode / ppppinnnppppin / Gegenelektrode
Elektrode / nnnnipppnnnnip / Gegenelektrode
Elektrode / ppppinnnnppppin / Gegenelektrode
Elektrode / nnnnippppnnnnip Gegenelektrode

Elektrode / pinninnnnn / Gegenelektrode
Elektrode / nippipppp / Gegenelektrode
Elektrode / pinnpinnnn / Gegenelektrode
Elektrode / nippnipppp / Gegenelektrode
Elektrode / pinppinnnn / Gegenelektrode
Elektrode / nipnnipppp / Gegenelektrode
Elektrode / pinnppinnnn / Gegenelektrode
Elektrode / nippnnipppp / Gegenelektrode
Elektrode / pinnninnnn / Gegenelektrode
Elektrode / nipppipppp / Gegenelektrode
Elektrode / pinnnpinnnn / Gegenelektrode
Elektrode / nipppnipppp / Gegenelektrode
Elektrode / pinpppinnnn / Gegenelektrode
Elektrode / nipnnnipppp / Gegenelektrode
Elektrode / pinnnppinnnn / Gegenelektrode
Elektrode / nipppnnipppp / Gegenelektrode
Elektrode / pinnpppinnnn / Gegenelektrode
Elektrode / nippnnnipppp / Gegenelektrode
Elektrode / pinnnpppinnnn / Gegenelektrode
Elektrode / nipppnnnipppp / Gegenelektrode
Elektrode / pinnnninnnn / Gegenelektrode
Elektrode / nippppipppp / Gegenelektrode
Elektrode / pinnnnpinnnn / Gegenelektrode
Elektrode / nippppnipppp / Gegenelektrode
Elektrode / pinppppinnnn / Gegenelektrode
Elektrode / nipnnnnipppp / Gegenelektrode
Elektrode / pinnnnppinnnn / Gegenelektrode
Elektrode / nippppnnipppp / Gegenelektrode
Elektrode / pinnppppinnnn / Gegenelektrode
Elektrode / nippnnnnipppp / Gegenelektrode
Elektrode / pinnnnpppinnnn / Gegenelektrode
Elektrode / nippppnnnipppp / Gegenelektrode
Elektrode / pinnnppppinnnn / Gegenelektrode
Elektrode / nipppnnnnipppp / Gegenelektrode
Elektrode / pinnnnppppinnnn / Gegenelektrode
Elektrode / nippppnnnnipppp / Gegenelektrode

Elektrode / ppinninn / Gegenelektrode
Elektrode / nnippipp / Gegenelektrode
Elektrode / ppinnpinn / Gegenelektrode
Elektrode / nnippnipp / Gegenelektrode
Elektrode / ppinppinn / Gegenelektrode
Elektrode / nnipnnipp / Gegenelektrode
Elektrode / ppinnppinn / Gegenelektrode
Elektrode / nnippnnipp / Gegenelektrode
Elektrode / ppinnninn / Gegenelektrode
Elektrode / nnipppipp / Gegenelektrode
Elektrode / ppinnnpinn / Gegenelektrode
Elektrode / nnipppnipp / Gegenelektrode
Elektrode / ppinpppinn / Gegenelektrode
Elektrode / nnipnnnipp / Gegenelektrode
Elektrode / ppinnnppinn / Gegenelektrode
Elektrode / nnipppnriipp / Gegenelektrode
Elektrode / ppinnpppinn / Gegenelektrode
Elektrode / nnippnnnipp / Gegenelektrode
Elektrode / ppinnnpppinn / Gegenelektrode
Elektrode / nnipppnnnipp / Gegenelektrode
Elektrode / ppinnnninn / Gegenelektrode
Elektrode / nnippppipp / Gegenelektrode
Elektrode / ppinnnnpinn / Gegenelektrode
Elektrode / nnippppnipp / Gegenelektrode
Elektrode / ppinppppinn / Gegenelektrode
Elektrode / nnipnnnnipp / Gegenelektrode
Elektrode / ppinnnnppinn / Gegenelektrode
Elektrode / nnippppnnipp / Gegenelektrode
Elektrode / ppinnppppinn / Gegenelektrode
Elektrode / nnippnnnnipp / Gegenelektrode
Elektrode / ppinnnnpppinn / Gegenelektrode
Elektrode / nnippppnnnipp / Gegenelektrode
Elektrode / ppinnnppppinn / Gegenelektrode
Elektrode / nnipppnnnnipp / Gegenelektrode
Elektrode / ppinnnnppppinn / Gegenelektrode
Elektrode / nnippppnnnnipp / Gegenelektrode

Elektrode / pppinninn / Gegenelektrode
Elektrode / nnnippipp / Gegenelektrode
Elektrode / pppinnpinn / Gegenelektrode
Elektrode / nnnippnipp / Gegenelektrode
Elektrode / pppinppinn / Gegenelektrode
Elektrode / nnnipnnipp / Gegenelektrode
Elektrode / pppinnppinn / Gegenelektrode
Elektrode / nnnippnnipp / Gegenelektrode
Elektrode / pppinnninn / Gegenelektrode
Elektrode / nnnipppipp / Gegenelektrode
Elektrode / pppinnnpinn / Gegenelektrode
Elektrode / nnnipppnipp / Gegenelektrode
Elektrode / pppinpppinn / Gegenelektrode
Elektrode / nnnipnnnipp / Gegenelektrode
Elektrode / pppinnnppinn / Gegenelektrode
Elektrode / nnnipppnnipp / Gegenelektrode
Elektrode / pppinnpppinn / Gegenelektrode
Elektrode / nnnippnnnipp / Gegenelektrode
Elektrode / pppinnnpppinn / Gegenelektrode
Elektrode / nnnipppnnnipp / Gegenelektrode
Elektrode / pppinnnninn / Gegenelektrode
Elektrode / nnnippppipp / Gegenelektrode
Elektrode / pppinnnnpinn / Gegenelektrode
Elektrode / nnnippppnipp / Gegenelektrode
Elektrode / pppinppppinn / Gegenelektrode
Elektrode / nnnipnnnnipp / Gegenelektrode
Elektrode / pppinnnnppinn / Gegenelektrode
Elektrode / nnnippppnnipp / Gegenelektrode
Elektrode / pppinnppppinn / Gegenelektrode
Elektrode / nnnippnnnnipp / Gegenelektrode
Elektrode / pppinnnnpppinn / Gegenelektrode
Elektrode / nnnippppnnnipp / Gegenelektrode
Elektrode / pppinnnppppinn / Gegenelektrode
Elektrode / nnnipppnnnnipp / Gegenelektrode
Elektrode / pppinnnnppppinn / Gegenelektrode
Elektrode / nnnippppnnnnipp / Gegenelektrode

Elektrode / ppinninnn / Gegenelektrode
Elektrode / nnippippp / Gegenelektrode
Elektrode / ppinnpinnn / Gegenelektrode
Elektrode / nnippnippp / Gegenelektrode
Elektrode / ppinppinnn / Gegenelektrode
Elektrode / nnipnnippp / Gegenelektrode
Elektrode / ppinnppinnn / Gegenelektrode
Elektrode / nnippnnippp / Gegenelektrode
Elektrode / ppinnninnn / Gegenelektrode
Elektrode / nhipppippp / Gegenelektrode
Elektrode / ppinnnpinnn / Gegenelektrode
Elektrode / nnipppnippp / Gegenelektrode
Elektrode / ppinpppihnn / Gegenelektrode
Elektrode / riniprinnippp / Gegenelektrode
Elektrode / ppinnnppinnn / Gegenelektrode
Elektrode / nnipppnnippp / Gegenelektrode
Elektrode / ppinnpppinnn / Gegenelektrode
Elektrode / nnippnnnippp / Gegenelektrode
Elektrode / ppinnnpppinnn / Gegenelektrode
Elektrode / nnipppnnnippp / Gegenelektrode
Elektrode / ppinnnninnn / Gegenelektrode
Elektrode / nnippppippp / Gegenelektrode
Elektrode / ppinnnnpinnn / Gegenelektrode
Elektrode / nnippppnippp / Gegenelektrode
Elektrode / ppinppppinnn / Gegenelektrode
Elektrode / nnipnnnnippp / Gegenelektrode
Elektrode / ppinnnnppinnn / Gegenelektrode
Elektrode / nnippppnnippp / Gegenelektrode
Elektrode / ppinnppppinnn / Gegenelektrode
Elektrode / nnippnnnnippp / Gegenelektrode
Elektrode / ppinnnnpppinnn / Gegenelektrode
Elektrode / nnippppnnnippp / Gegenelektrode
Elektrode / ppinnnppppinnn / Gegenelektrode
Elektrode / nnipppnnnnippp / Gegenelektrode
Elektrode / ppinnnnppppinnn / Gegenelektrode
Elektrode / nnippppnnnnippp / Gegenelektrode

Elektrode / ppppinninn / Gegenelektrode
Elektrode / nnnnippipp / Gegenelektrode
Elektrode / ppppinnpinn / Gegenelektrode
Elektrode / nnnnippnipp / Gegenelektrode
Elektrode ppppinppinn / Gegenelektrode
Elektrode / nnnnipnnipp / Gegenelektrode
Elektrode / ppppinnppinn / Gegenelektrode
Elektrode / nnnnippnnipp / Gegenelektrode
Elektrode / ppppinnninn / Gegenelektrode
Elektrode / nnnnipppipp / Gegenelektrode
Elektrode / ppppinnnpinn / Gegenelektrode
Elektrode / nnnnipppnipp / Gegenelektrode
Elektrode / ppppinpppinn / Gegenelektrode
Elektrode / nnnnipnnnipp / Gegenelektrode
Elektrode / ppppinnnppinn / Gegenelektrode
Elektrode / nnnnipppnnipp / Gegenelektrode
Elektrode / ppppinnpppinn / Gegenelektrode
Elektrode / nnnnippnnnipp / Gegenelektrode
Elektrode / ppppinnnpppinn / Gegenelektrode
Elektrode / nnnnipppnnnipp / Gegenelektrode
Elektrode / ppppinnnninn / Gegenelektrode
Elektrode / nnnnippppipp / Gegenelektrode
Elektrode / ppppinnnnpinn / Gegenelektrode
Elektrode / nnnnippppnipp / Gegenelektrode
Elektrode / ppppinppppinn / Gegenelektrode
Elektrode / nnnnipnnnnipp / Gegenelektrode
Elektrode / ppppinnnnppinn / Gegenelektrode
Elektrode / nnnnippppnnipp / Gegenelektrode
Elektrode / ppppinnppppinn / Gegenelektrode
Elektrode / nnnnippnnnnipp / Gegenelektrode
Elektrode / ppppinnnnpppinn / Gegenelektrode
Elektrode / nnnnippppnnnipp / Gegenelektrode
Elektrode / ppppinnnppppinn / Gegenelektrode
Elektrode / nnnnipppnnnnipp / Gegenelektrode
Elektrode / ppppinnnnppppinn / Gegenelektrode
Elektrode / nnrtnippppnnnnipp / Gegenelektrode

Elektrode / ppinninnnhn / Gegenelektrode
Elektrode / nnippipppp / Gegenelektrode
Elektrode / ppinnpinnnn / Gegenelektrode
Elektrode / nnippnipppp / Gegenelektrode
Elektrode / ppinppinnnn / Gegenelektrode
Elektrode / nnipnnipppp / Gegenelektrode
Elektrode / ppinnppinnnn / Gegenelektrode
Elektrode / nnippnhipppp / Gegenelektrode
Elektrode / ppinnninnnn / Gegenelektrode
Elektrode / nnipppipppp / Gegenelektrode
Elektrode / ppinnnpinnnn / Gegenelektrode
Elektrode / nnipppnipppp / Gegenelektrode
Elektrode / ppinpppinnnn / Gegenelektrode
Elektrode / nnipnnnipppp / Gegenelektrode
Elektrode / ppinnnppinnnn / Gegenelektrode
Elektrode / nnipppnnipppp / Gegenelektrode
Elektrode / ppinnpppinnnn / Gegenelektrode
Elektrode / nnippnnnipppp / Gegenelektrode
Elektrode / ppinnnpppinnnn / Gegenelektrode
Elektrode / nnipppnnnipppp / Gegenelektrode
Elektrode / ppinnnninnnn / Gegenelektrode
Elektrode / nnippppipppp / Gegenelektrode
Elektrode / ppinnnnpinnnn / Gegenelektrode
Elektrode / nnippppnipppp/ Gegenelektrode
Elektrode / ppinppppinnnn / Gegenelektrode
Elektrode / nnipnnnnipppp / Gegenelektrode
Elektrode / ppinnnnppinnnn / Gegenelektrode
Elektrode / nnippppnnipppp / Gegenelektrode
Elektrode / ppinnppppinnnn / Gegenelektrode
Elektrode / nnippnnnnipppp / Gegenelektrode
Elektrode / ppinnnnpppinnnn / Gegenelektrode
Elektrode / nnippppnnnipppp / Gegenelektrode
Elektrode / ppinnnppppinnnn / Gegenelektrode
Elektrode / nnipppnnnnipppp / Gegenelektrode
Elektrode / ppinnnnppppinnnn / Gegenelektrode
Elektrode / nnippppnnnnipppp / Gegenelektrode

Elektrode / ppppinninnn / Gegenelektrode
Elektrode / nnnippippp / Gegenelektrode
Elektrode / pppinnpinnn / Gegenelektrode
Elektrode / nnnippnippp / Gegenelektrode
Elektrode / pppinppinnn / Gegenelektrode
Elektrode / nnnipnnippp / Gegenelektrode
Elektrode / pppinnppinnn / Gegenelektrode
Elektrode / nnnippnnippp Gegenelektrode
Elektrode / pppinnninnn / Gegenelektrode
Elektrode / nnnipppippp / Gegenelektrode
Elektrode / pppinnnpinnn / Gegenelektrode
Elektrode / nnnipppnippp / Gegenelektrode
Elektrode / pppinpppinrin / Gegenelektrode
Elektrode / nnnipnnnippp / Gegenelektrode
Elektrode / pppinnnppinnn / Gegenelektrode
Elektrode / nnnipppnnippp / Gegenelektrode
Elektrode / pppinnpppinnn / Gegenelektrode
Elektrode / nnnippnnnippp / Gegenelektrode
Elektrode / pppinnnpppinnn / Gegenelektrode
Elektrode / nnnipppnnnippp / Gegenelektrode
Elektrode / pppinnnninnn / Gegenelektrode
Elektrode / nnnippppippp / Gegenelektrode
Elektrode / pppinnnnpinnn / Gegenelektrode
Elektrode / nnnippppnippp / Gegenelektrode
Elektrode / pppinppppinnn / Gegenelektrode
Elektrode / nnnipnnnnippp / Gegenelektrode
Elektrode / pppinnnnppinnn / Gegenelektrode
Elektrode / nnnippppnnippp / Gegenelektrode
Elektrode / pppinnppppinnn / Gegenelektrode
Elektrode / nnnippnnnnippp / Gegenelektrode
Elektrode / pppinnnnpppinnn / Gegenelektrode
Elektrode / nnnippppnnnippp / Gegenelektrode
Elektrode / pppinnnppppinnn / Gegenelektrode
Elektrode / nnnipppnnnnippp / Gegenelektrode
Elektrode / pppinnnnppppinnn / Gegenelektrode
Elektrode / nnnippppnnnnippp / Gegenelektrode

Elektrode / ppppinninnn / Gegenelektrode
Elektrode / nnnnippippp / Gegenelektrode
Elektrode / ppppinnpinnn / Gegenelektrode
Elektrode / nnnnippnippp / Gegenelektrode
Elektrode / ppppinppinnn / Gegenelektrode
Elektrode / nnnnipnnippp / Gegenelektrode
Elektrode / ppppinnppinnn / Gegenelektrode
Elektrode / nnnnippnnippp / Gegenelektrode
Elektrode / ppppinnninnn / Gegenelektrode
Elektrode / nnnnipppippp / Gegenelektrode
Elektrode / ppppinnnpinnn / Gegenelektrode
Elektrode / nnnhipppnippp / Gegenelektrode
Elektrode / ppppinpppinnn / Gegenelektrode
Elektrode / nnnnipnnnippp / Gegenelektrode
Elektrode / ppppinnnppinnn / Gegenelektrode
Elektrode / nnnnipppnnippp / Gegenelektrode
Elektrode / ppppinnpppinnn / Gegenelektrode
Elektrode / nnnnippnnnippp / Gegenelektrode
Elektrode / ppppinnnpppinnn / Gegenelektrode
Elektrode / nnnnipppnnnippp / Gegenelektrode
Elektrode / ppppinnnninnn / Gegenelektrode
Elektrode / nnnnippppippp / Gegenelektrode
Elektrode / ppppinnnnpinnn / Gegenelektrode
Elektrode / nnnnippppnippp / Gegenelektrode
Elektrode / ppppinppppinnn / Gegenelektrode
Elektrode / nnnnipnnnnippp / Gegenelektrode
Elektrode / ppppinnnnppinnn / Gegenelektrode
Elektrode / nnnnippppnnippp / Gegenelektrode
Elektrode / ppppinnppppinnn / Gegenelektrode
Elektrode / nnnnippnnnnippp / Gegenelektrode
Elektrode / ppppinnnnpppinnn / Gegenelektrode
Elektrode / nnnnippppnnnippp / Gegenelektrode
Elektrode / ppppinnnppppinnn / Gegenelektrode
Elektrode / nnnnipppnnnnippp / Gegenelektrode
Elektrode / ppppinnnnppppinnn / Gegenelektrode
Elektrode / nnnnippppnnnnippp / Gegenelektrode

Elektrode / pppinninnnn / Gegenelektrode
Elektrode / nnnippipppp / Gegenelektrode
Elektrode / pppinnpinnnn / Gegenelektrode
Elektrode / nnnippnipppp / Gegenelektrode
Elektrode / pppinppinnnn / Gegenelektrode
Elektrode / nnnipnnipppp / Gegenelektrode
Elektrode / pppinnppinnnn / Gegenelektrode
Elektrode / nnnippnnipppp / Gegenelektrode
Elektrode / pppinnninnnn / Gegenelektrode
Elektrode / nnnipppipppp / Gegenelektrode
Elektrode / pppinnnpinnnn / Gegenelektrode
Elektrode / nnnipppnipppp / Gegenelektrode
Elektrode / pppinpppinnnn / Gegenelektrode
Elektrode / nnnipnnnipppp / Gegenelektrode
Elektrode / pppinnnppinnnn / Gegenelektrode
Elektrode / nnnipppnnipppp / Gegenelektrode
Elektrode / pppinnpppinnnn / Gegenelektrode
Elektrode / nnnippnnnipppp / Gegenelektrode
Elektrode / pppinnnpppinnnn / Gegenelektrode
Elektrode / nnnipppnnnipppp / Gegenelektrode
Elektrode / pppinnnninnnn / Gegenelektrode
Elektrode / nnnippppipppp / Gegenelektrode
Elektrode / pppinnnnpinnnn / Gegenelektrode
Elektrode / nnnippppnipppp / Gegenelektrode
Elektrode / pppinppppinnnn / Gegenelektrode
Elektrode / nnnipnnnnipppp / Gegenelektrode
Elektrode / pppinnnnppinnnn / Gegenelektrode
Elektrode / nnnippppnnipppp / Gegenelektrode
Elektrode / pppinnppppinnnn / Gegenelektrode
Elektrode / nnnippnnnriipppp / Gegenelektrode
Elektrode / pppinnnnpppinnnn / Gegenelektrode
Elektrode / nnnippppnnnipppp / Gegenelektrode
Elektrode / pppinnnppppinnnn / Gegenelektrode
Elektrode / nnnipppnnnnipppp / Gegenelektrode
Elektrode / pppinnnnppppinnnn / Gegenelektrode
Elektrode / nnnippppnnnnipppp / Gegenelektrode

Elektrode / ppppinninnnn / Gegenelektrode
Elektrode / nnnnippipppp / Gegenelektrode
Elektrode / ppppinnpinnnn / Gegenelektrode
Elektrode / nnnnippnipppp / Gegenelektrode
Elektrode / ppppinppinnnn / Gegenelektrode
Elektrode / nnnnipnnipppp / Gegenelektrode
Elektrode / ppppinnppinnnn / Gegenelektrode
Elektrode / nnnnippnnipppp / Gegenelektrode
Elektrode / ppppinnninnnn / Gegenelektrode
Elektrode / nnnnipppipppp / Gegenelektrode
Elektrode / ppppinnnpinnnn / Gegenelektrode
Elektrode / nnnnipppnipppp / Gegenelektrode
Elektrode / ppppinpppinnnn / Gegenelektrode
Elektrode / nnnnipnnnipppp / Gegenelektrode
Elektrode / ppppinnnppinnnn / Gegenelektrode
Elektrode / nnnnipppnnipppp / Gegenelektrode
Elektrode / ppppinnpppinnnn / Gegenelektrode
Elektrode / nnnnippnnnipppp / Gegenelektrode
Elektrode / ppppinnnpppinnnn / Gegenelektrode
Elektrode / nnnnipppnnnipppp / Gegenelektrode
Elektrode / ppppinnnninnnn / Gegenelektrode
Elektrode / nnnnippppipppp / Gegenelektrode
Elektrode / ppppinnnnpinnnn / Gegenelektrode
Elektrode / nnnnippppnipppp / Gegenelektrode
Elektrode / ppppinppppinnnn / Gegenelektröde
Elektrode / nnnnipnnnnipppp / Gegenelektrode
Elektrode / ppppinnnnppinnnn / Gegenelektrode
Elektrode / nnnnippppnnipppp / Gegenelektrode
Elektrode / ppppinnppppinnnn / Gegenelektrode
Elektrode / nnnnippnnnnipppp / Gegenelektrode
Elektrode / ppppinnnnpppinnnn / Gegenelektrode
Elektrode / nnnnippppnnnipppp / Gegenelektrode
Elektrode / ppppinnnppppinnnn / Gegenelektrode
Elektrode / nnnnipppnnnnipppp / Gegenelektrode
Elektrode / ppppinnnnppppinnnn / Gegenelektrode
Elektrode / nnnnippppnnnnipppp / Gegenelektrode

In einer weiteren Ausführung der Erfindung ist an den Elektroden noch ein Konversionskontakt vorhanden. Aus einer Elektrode / p Struktur wird somit eine Elektrode / n / p Struktur bzw. aus einer Elektrode / n Struktur wird eine Elektrode / p / n Struktur. Diese Konversionskontakte können sowohl an der Elektrode als auch an der Gegenelektrode vorhanden sein. Der Konversionskontakt kann auch aus mehreren Transportschichtsystemen bestehen, z.B.:
Elektrode / nnp
Elektrode / nnnp
Elektrode / nnnnp
Elektrode / ppn
Elektrode / pppn
Elektrode / ppppn

In einer weiteren Ausführung der Erfindung sind die Konversionskontakte in allen in den obigen Listen beschriebenen Strukturen vorhanden, z.B. ist die erste Struktur in den obigen Listen Elektrode / pinnin / Gegenelektrode wie folgt mit Konversionskontakten erweiterbar:
Elektrode / npinnin / Gegenelektrode
Elektrode / nnpinnin / Gegenelektrode
Elektrode / nnnpinnin / Gegenelektrode
Elektrode / nnnnpinnin / Gegenelektrode
Elektrode / pinninp / Gegenelektrode
Elektrode / pinninpp / Gegenelektrode
Elektrode / pinninppp / Gegenelektrode
Elektrode / pinninppp / Gegenelektrode
Elektrode / npinninp / Gegenelektrode
Elektrode / npinninpp / Gegenelektrode
Elektrode / npinninppp / Gegenelektrode
Elektrode / npinninpppp / Gegenelektrode
Elektrode / nnpinninp / Gegenelektrode
Elektrode / nnnpinninp / Gegenelektrode
Elektrode / nnnnpinninp / Gegenelektrode
Elektrode / nnpinninpp / Gegenelektrode
Elektrode / nnnpinninpp / Gegenelektrode
Elektrode / nnnnpinninpp / Gegenelektrode
Elektrode / nnpinninppp / Gegenelektrode
Elektrode / npinninpppp / Gegenelektrode
Elektrode / nnnpinninppp / Gegenelektrode
Elektrode / nnnnpinninppp / Gegenelektrode
Elektrode / nnnpinninpppp / Gegenelektrode
Elektrode / nnnnpinninpppp / Gegenelektrode

Die letzte Struktur in den obigen Listen Elektrode / nnnnippppnnnnipppp / Gegenelektrode ist analog wie folgt mit Konversionskontakten erweiterbar:
Elektrode / pnnnnippppnnnnipppp / Gegenelektrode
Elektrode / ppnnnnippppnnnnipppp / Gegenelektrode
Elektrode / ppnnnnippppnnnnipppp / Gegenelektrode
Elektrode / pppnnnnippppnnnnipppp / Gegenelektrode
Elektrode / ppppnnnnippppnnnnipppp / Gegenelektrode
Elektrode / nnnnippppnnnnippppn / Gegenelektrode
Elektrode / nnnnippppnnnnippppnn / Gegenelektrode
Elektrode / nnnnippppnnnnippppnnn / Gegenelektrode
Elektrode / nnnnippppnnnnippppnnnn / Gegenelektrode
Elektrode / pnnnnippppnnnnippppn / Gegenelektrode
Elektrode / ppnnnnippppnnnnippppn / Gegenelektrode
Elektrode / pppnnnnippppnnnnippppn / Gegenelektrode
Elektrode / ppppnnnnippppnnnnippppn / Gegenelektrode
Elektrode / pnnnnippppnnnnippppnn / Gegenelektrode
Elektrode / pnnnnippppnnnnippppnnn / Gegenelektrode
Elektrode / pnnnnippppnnnnippppnnnn / Gegenelektrode
Elektrode / ppnnnnippppnnnnippppnn / Gegenelektrode
Elektrode / pppnnnnippppnnnnippppnn / Gegenelektrode
Elektrode / ppppnnnnippppnnnnippppnn / Gegenelektrode
Elektrode / ppnnnnippppnnnnippppnnn / Gegenelektrode
Elektrode / ppnnnnippppnnnnippppnnnn / Gegenelektrode
Elektrode / pppnnnnippppnnnnippppnnn / Gegenelektrode
Elektrode / ppppnnnnippppnnnnippppnnn / Gegenelektrode
Elektrode / ppppnnnnippppnnnnippppnnnn / Gegenelektrode

In einer weiteren Ausführungsform der Erfindung ist zwischen der ersten elektronenleitenden Schicht (n-Schicht) und der auf dem Substrat befindlichen Elektrode noch eine p-dotierte Schicht vorhanden, so dass es sich um eine pnip oder pni-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform der Erfindung kann in dem Bauelement zwischen der ersten photoaktiven i-Schicht und der auf dem Substrat befindlichen Elektrode noch eine p-dotierte Schicht vorhanden sein, so dass es sich um eine pip oder pi-Struktur handelt, wobei die zusätzliche p-dotierte Schicht eine Ferminiveaulage hat, die höchstens 0,4eV, bevorzugt aber weniger als 0,3eV unterhalb des Elektronentransportniveaus der i-Schicht liegt, so dass es zu verlustarmer Elektronenextraktion aus der i-Schicht in diese p-Schicht kommen kann.

In einer weiteren Ausführungsform der Erfindung ist noch ein n-Schichtsystem zwischen der p-dotierten Schicht und der Gegenelektrode vorhanden, so dass es sich um eine nipn oder ipn-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform kann in dem Bauelement noch ein n-Schichtsystem zwischen der intrinsischen, photoaktiven Schicht und der Gegenelektrode vorhanden sein, so dass es sich um eine nin- oder in-Struktur handelt, wobei die zusätzliche n-dotierte Schicht eine Ferminiveaulage hat, die höchstens 0,4eV, bevorzugt aber weniger als 0,3eV oberhalb des Löchertransportnivaus der i-Schicht liegt, so dass es zu verlustarmer Löcherextraktion aus der i-Schicht in diese n-Schicht kommen kann.

In einer weiteren Ausführungsform der Erfindung enthält das Bauelement ein n-Schichtsystem und/oder ein p-Schichtsystem , so dass es sich um eine pnipn, pnin, pipn- oder p-i-n-Struktur handelt, die sich in allen Fällen dadurch auszeichnen, dass - unabhängig vom Leitungstyp - die substratseitig an die photoaktive i-Schicht angrenzende Schicht eine geringere thermische Austrittsarbeit hat als die vom Substrat abgewandte an die i-Schicht grenzende Schicht, so dass photogenerierte Elektronen bevorzugt zum Substrat hin abtransportiert werden, wenn keine externe Spannung an das Bauelement angelegt wird.

In einer weiteren Ausführungsform der Erfindung erstreckt sich der Absorptionsbereich zumindest eines der Absorbersysteme in den Infrarot-Bereich im Wellenlängenbereich von >700nm bis 1500nm.

In einer weiteren Ausführungsform der Erfindung sind die Schichten des Schichtsystems des Bauelements als eine den optischen Weg des einfallenden Lichts verlängernde Lichtfalle ausgebildet.

In einer weiteren Ausführungsform der Erfindung handelt es sich bei den verwendeten organischen Materialien um kleine Moleküle. Unter kleinen Molekülen werden im Sinne der vorliegenden Erfindung nicht-polymere organische Moleküle mit monodispersen Molmassen zwischen 100 und 2000 verstanden, die unter Normaldruck (Luftdruck der uns umgebenden Atmosphäre) und bei Raumtemperatur in fester Phase vorliegen. Insbesondere könnend diese kleinen Molekülen auch photoaktiv sein, wobei unter photoaktiv verstanden wird, dass die Moleküle unter Lichteinfall ihren Ladungszustand ändern.

In einer weiteren Ausführungsform der Erfindung handelt es sich bei den verwendeten organischen Materialien zumindest teilweise um Polymere.

In einer weiteren Ausführungsform der Erfindung bestehen die organischen Schichten zumindest teilweise aus kleinen Molekülen, zumindest teilweise aus Polymeren oder aus einer Kombination von kleinen Molekülen und Polymeren.

In einer weiteren Ausführungsform der Erfindung ist das Bauelement zumindest in einem gewissen Lichtwellenlängenbereich semitransparent.

In einer weiteren Ausführungsform der Erfindung wird das Bauelement auf ebenen, gekrümmten oder flexiblen Trägerflächen verwendet. Bevorzugt sind diese Trägerflächen Plastikfolien oder Metallfolien (z.B. Aluminium, Stahl), etc..

In einer weiteren Ausführungsform der Erfindung enthält mindestens eine der photoaktiven Mischschichten als Akzeptor ein Material aus der Gruppe der Fullerene bzw. Fullerenderivate (C₆₀, C₇₀, etc.).

In einer weiteren Ausführungsform der Erfindung enthält mindestens eine der photoaktiven Mischschichten als Donator ein Material aus der Klasse der Phthalocyanine, Perylenderivate, TPD-Derivate, Oligothiophene oder ein Material wie es in WO2006092134 beschrieben ist.

In einer weiteren Ausführungsform der Erfindung bestehen die Kontakte aus Metall, einem leitfähigen Oxid, insbesondere ITO, ZnO:Al oder anderen TCOs oder einem leitfähigen Polymer, insbesondere PEDOT:PSS oder PANI.

In einer weiteren Ausführungsform liegt das Akzeptor-Material in der Mischschicht zumindest teilweise in kristalliner Form vor..

In einer weiteren Ausführungsform liegt das Donator-Material in der Mischschicht zumindest teilweise in kristalliner Form vor.

In einer weiteren Ausführungsform liegen sowohl das Akzeptor-Material als auch das Donator-Material in der Mischschicht zumindest teilweise in kristalliner Form vor. In einer weiteren Ausführungsform bestehen die photoaktiven Schichtsysteme aus einer Einzelschicht, einer Mischschicht, aus einer Kombination von Einzel- und Mischschichten, aus einer Doppelmischschicht oder aus einer Dreifachmischschicht.

In einer weiteren Ausführungsform enthält das photoaktive Schichtsystem zusätzlich zu der genannten Mischschicht noch weitere photoaktive Einzel- oder Mischschichten.

In einer weiteren Ausführungsform besteht das n-Materialsystem aus einer oder mehreren Schichten.

In einer weiteren Ausführungsform besteht das p-Materialsystem aus einer oder mehreren Schichten.

In einer weiteren Ausführungsform enthält das p-Transportschichtsystem einen p-Dotanden, wobei dieser p-Dotand F4-TCNQ, ein p-Dotand wie in DE10338406, DE10347856, DE10357044, DE102004010954, DE102006053320, DE102006054524 und DE102008051737 beschrieben oder ein Übergangsmetalloxid (VO, WO, MoO, etc.) ist.

In einer weiteren Ausführungsform enthält das n-Transportschichtsystem einen n-Dotanden, wobei dieser n-Dotand ein TTF-Derivat (Tetrathiafulvalen-Derivat) oder DTT-Derivat (Dithienothiophen), ein n-Dotand wie in DE10338406, DE10347856, DE10357044, DE102004010954, DE102006053320, DE102006054524 und DE102008051737 beschrieben oder Cs, Li oder Mg ist.

In einer weiteren Ausführungsform ist eine Elektrode transparent mit einer Transmission > 80% und die andere Elektrode reflektierend mit einer Reflektion > 50% ausgeführt.

In einer weiteren Ausführungsform ist das Bauelement semitransparent mit einer Transmission von 10-80% ausgeführt.

In einer weiteren Ausführungsform bestehen die Elektroden aus einem Metall (z.B. Al, Ag, Au oder eine Kombination aus diesen), einem leitfähigen Oxid, insbesondere ITO, ZnO:Al oder einem anderen TCO (Transparent Conductive Oxide), einem leitfähigen Polymer, insbesondere PEDOT/PSS Poly(3,4-ethylenedioxythiophene)poly(styrenesulfonate) oder PANI (Polyanilin), oder aus einer Kombination aus diesen Materialien.

In einer weiteren Ausführungsform wird die Lichtfalle dadurch realisiert, dass das Bauelement auf einem periodisch mikrostrukturierten Substrat aufgebaut wird und die homogene Funktion des Bauelements, also eine kurzschlussfreie Kontaktierung und homogene Verteilung des elektrischen Feldes über die gesamte Fläche, durch die Verwendung einer dotierten wide-gap-Schicht gewährleistet wird. Ultradünne Bauelemente weisen auf strukturierten Substraten eine erhöhten Gefahr zur Bildung lokaler Kurzschlüsse auf, so dass durch eine solche offensichtliche Inhomogenität letztlich die Funktionalität des gesamten Bauelements gefährdet ist. Diese Kurzschlussgefahr wird durch die Verwendung der dotierten Transportschichten verringert.

In einer weiteren Ausführungsform der Erfindung wird die Lichtfalle dadurch realisiert, dass das Bauelement auf einem periodisch mikrostrukturierten Substrat aufgebaut wird und die homogene Funktion des Bauelementes, dessen kurzschlussfreie Kontaktierung und eine homogene Verteilung des elektrischen Feldes über die gesamte Fläche durch die Verwendung einer dotierten wide-gap-Schicht gewährleistet wird. Besonders vorteilhaft ist dabei, dass das Licht die Absorberschicht mindestens zweimal durchläuft, was zu einer erhöhten Lichtabsorption und dadurch zu einem verbesserten Wirkungsgrad der Solarzelle führen kann. Dies lässt sich beispielsweise dadurch erreichen, dass das Substrat pyramidenartige Strukturen auf der Oberfläche aufweist mit Höhen (h) und Breiten (d) jeweils im Bereich von einem bis zu mehreren hundert Mikrometern. Höhe und Breite können gleich oder unterschiedlich gewählt werden. Ebenfalls können die Pyramiden symmetrisch oder asymmetrisch aufgebaut sein.

In einer weiteren Ausführungsform der Erfindung wird die Lichtfalle dadurch realisiert, dass eine dotierte wide-gap-Schicht eine glatte Grenzflächen zur i-Schicht und eine rauhe Grenzfläche zum reflektierenden Kontakt hat. Die rauhe Grenzfläche kann beispielsweise durch eine periodische Mikrostrukturierung erreicht werden. Besonders vorteilhaft ist die rauhe Grenzfläche, wenn sie das Licht diffus reflektiert, was zu einer Verlängerung des Lichtweges innerhalb der photoaktiven Schicht führt.

In einer weiteren Ausführungsform wird die Lichtfalle dadurch realisiert, dass das Bauelement auf einem periodisch mikrostrukturierten Substrat aufgebaut wird und eine dotierte wide-gap-Schicht eine glatte Grenzfläche zur i-Schicht und eine rauhe Grenzfläche zum reflektierenden Kontakt hat.

In einer weiteren Ausführungsform der Erfindung ist die Gesamtstruktur mit transparentem Grund- und Deckkontakt versehen.

In einer weiteren Ausführungsform werden die erfindungsgemäßen photoaktiven Bauelemente auf gekrümmten Oberflächen, wie beispielsweise Beton, Dachziegeln, Ton, Autoglas, etc. verwendet. Dabei ist es vorteilhaft, dass die erfindungsgemäßen organischen Solarzellen gegenüber herkömmlichen anorganischen Solarzellen auf flexiblen Trägern wie Folien, Textilen, etc. aufgebracht werden können.

In einer weiteren Ausführungsform werden die erfindungsgemäßen photoaktiven Bauelemente auf eine Folie oder Textil aufgebracht, welche auf der, mit dem erfindungsgemäßen organischen Schichtsystem gegenüberliegenden Seite ein Adhäsionsmittel, wie beispielsweise einen Klebstoff aufweist. Dadurch ist es möglich eine Solarklebefolie herzustellen, welche nach Bedarf auf beliebigen Oberflächen angeordnet werden kann. So kann eine selbsthaftende Solarzelle erzeugt werden.

Nachfolgend soll die Erfindung anhand einiger Ausführungsbeispiele und dazugehöriger Figuren eingehender erläutert werden. Es zeigen in
Fig.1A und 1B den schematischen Schichtaufbau eines photoaktiven Bauelementes mit zwei Transportschichtsystemen zwischen den photoaktiven Schichtsystemen, in
Fig.2A und 2B den schematischen Schichtaufbau eines photoaktiven Bauelementes mit drei Transportschichtsystemen zwischen den photoaktiven Schichtsystemen, in
Fig.3 den schematischen Schichtaufbau eines photoaktiven Bauelementes mit vier Transportschichtsystemen zwischen den photoaktiven Schichtsystemen, in
Fig.4A und 4B den schematischen Schichtaufbau eines photoaktiven Bauelementes mit vier Transportschichtsystemen zwischen den photoaktiven Schichtsystemen und drei Transportschichtsystemen an der Elektrode, in
Fig.5 den schematischen Schichtaufbau eines photoaktiven Bauelementes mit vier Transportschichtsystemen zwischen den photoaktiven Schichtsystemen, drei Transportschichtsystemen an der Elektrode und drei Transportschichtsystemen an der Gegenelektrode, in
Fig.6 ein schematisches Energiediagramm eines photoaktiven Bauelementes mit drei Transportschichtsystemen zwischen den photoaktiven Schichtsystemen, in
Fig.7 ein schematisches Energiediagramm eines photoaktiven Bauelementes mit drei Transportschichtsystemen zwischen den photoaktiven Schichtsystemen, in
Fig.8 ein schematisches Energiediagramm eines photoaktiven Bauelementes mit vier Transportschichtsystemen zwischen den photoaktiven Schichtsystemen, in
Fig.9 ein schematisches Energiediagramm eines photoaktiven Bauelementes mit sechs Transportschichtsystemen zwischen den photoaktiven Schichtsystemen, in
Fig. 10 ein schematisches Energiediagramm eines photoaktiven Bauelementes mit acht Transportschichtsystemen zwischen den photoaktiven Schichtsystemen, in
Fig.11A und B ein schematischer Schichtaufbau von zwei beispielhaften photoaktiven Bauelementen, in
Fig. 12 die Strukturformeln der Materialien DCV6T, F4-ZnPc und C60 und in
Fig. 13 den Schematischen Schichtaufbau eines beispielhaften photoaktiven Bauelementes analog zu Fig. 11, wobei zwischen den photoaktiven Absorbersystemen drei verschiedene p-Transportschichtsysteme 1, 2 und 3 vorhanden sind.

In den aufgeführten Ausführungsbeispielen sind beispielhaft einige erfindungsgemäßen Bauelemente aufgezeigt. Die Ausführungsbeispiele sollen die Erfindung beschreiben ohne sich auf diese zu beschränken.

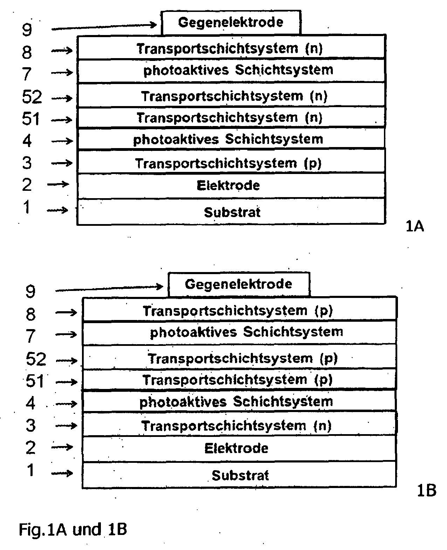

In einem ersten Ausführungsbeispiel ist in Fig. 1A schematisch ein erfindungsgemäßes Bauelement dargestellt. Diese besteht aus Substrat 1, einer Elektrode 2 sowie einer Gegenelektrode 9. Zwischen der Elektrode 2 und der Gegenelektrode 9 ist ein photoaktives Schichtsystem 4 angeordnet. Zwischen der Elektrode 2 und dem photoaktiven Schichtsystem 4 ist ein Transportschichtsystem 3 angeordnet, welches p-leitend ausgeführt ist. Zwischen der Gegenelektrode und dem photoaktiven Schichtsystem 4 sind weitere Schichten angeordnet. Dabei sind auf dem photoaktiven Schichtsystem 4 die erfindungsgemäßen Transportschichtsysteme 51 und 52 des gleichen Ladungsträgertyps (in diesem Fall Elektronen) angeordnet, wobei sich das LUMO-Niveau des Transportschichtsystems 51 um maximal 0,5eV vom LUMO des photoaktiven Schichtsystems 4 unterscheidet. Weiterhin ist das andere Transportschichtsystem 52 transparent ausgeführt. Auf den Transportschichtsystemen 51 und 52 ist ein weiteres photoaktives Schichtsystem 7 angeordnet. Zwischen dem weiteren photoaktiven Schichtsystem 7 und der Gegenelektrode 9 ist ein weiteres Transportschichtsystem 8 angeordnet, welches n-leitend ausgeführt ist. In der Figur 1B ist eine analoge Ausführung zum photoaktiven Bauelement in Fig. 1A dargestellt, wobei der Aufbau der Schichten des photoaktiven Bauelements in Fig.1B einer nip-Struktur entspricht.

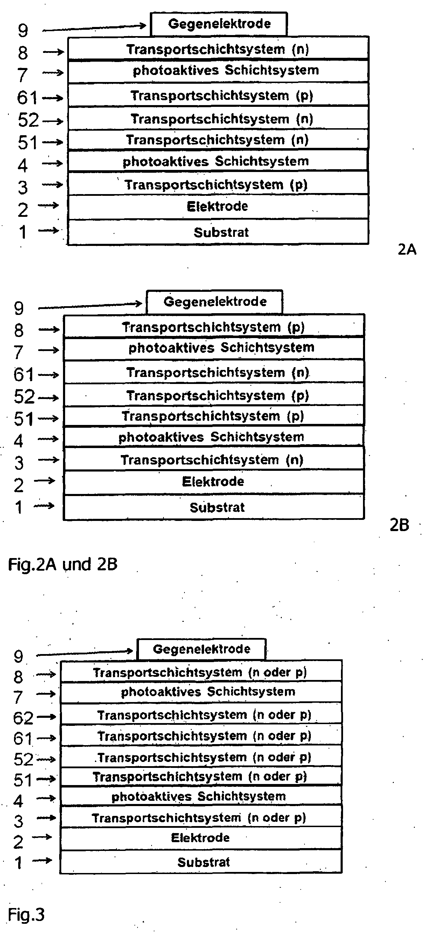

In einem zweiten Ausführungsbeispiel ist in Fig.2A und 2B jeweils eine schematische Darstellung eines erfindungsgemäßen Bauelements abgebildet. Der Aufbau des erfindungsgemäßen Bauelements ist analog dem ersten Ausführungsbeispiel in Fig.1A,B, wobei zwischen den photoaktiven Schichtsystemen 4,7 drei Transportschichtsysteme 51,52 und 61 angeordnet sind. Dadurch ergibt sich eine effiziente Ladungsträgerrekombination an der Grenzfläche zwischen den Transportschichtsystemen 52 und 61.

In einem dritten Ausführungsbeispiel ist in Fig.3 eine schematische Darstellung eines erfindungsgemäßen Bauelements abgebildet. Der Aufbau des erfindungsgemäßen Bauelements ist analog dem Ausführungsbeispiel in Fig.2, wobei zwischen den photoaktiven Schichtsystemen 4,7 vier Transportschichtsysteme 51,52,61 und 62 angeordnet sind.

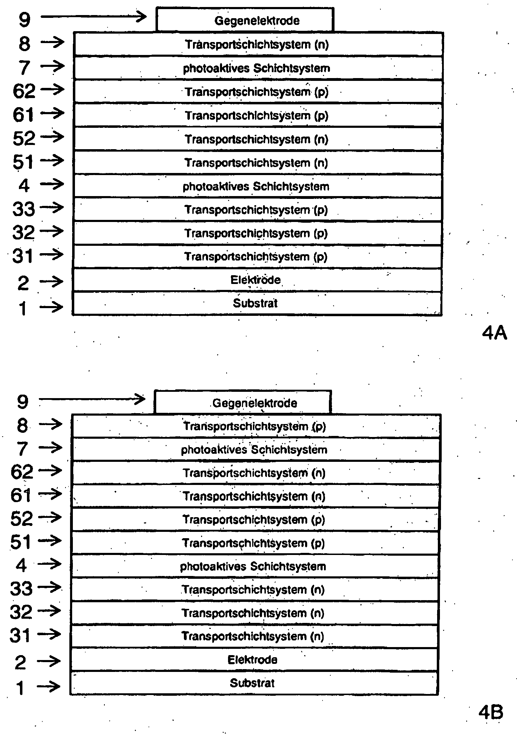

In einem vierten Ausführungsbeispiel ist in Fig.4A und 4B eine schematische Darstellung eines erfindungsgemäßen Bauelements abgebildet. Der Aufbau des erfindungsgemäßen Bauelements ist analog dem Ausführungsbeispiel in Fig.3, wobei drei Transportschichtsysteme 31,32 und 33 zwischen dem photoaktiven Schichtsystem 4 und der Elektrode 2 angeordnet sind. Das in Fig.4A schematisch dargestellte Bauelement entspricht hierbei einer pin-Grundstruktur(speziell einer pnnppn-Struktur), während das in Fig.4B dargestellte Bauelement einer nip-Struktur entspricht, hier einer nppnnp-Struktur.

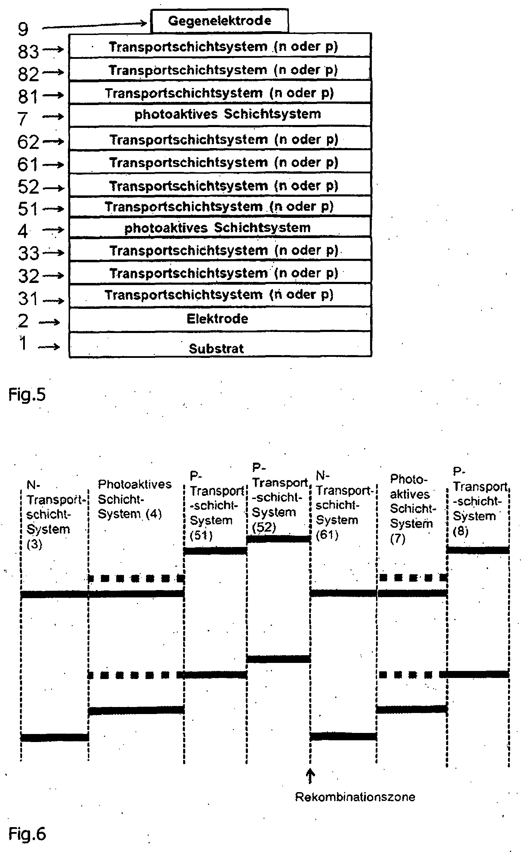

In einem fünften Ausführungsbeispiel ist in Fig.5 eine schematische Darstellung eines erfindungsgemäßen Bauelements abgebildet. Der Aufbau des erfindungsgemäßen Bauelements ist analog dem Ausführungsbeispielen in Fig.4A und B, wobei die Transportschichtsysteme 81,82 und 83 zwischen dem photoaktiven Schichtsystem 7 und der Gegenelektrode 9 angeordnet sind.

In der Fig.6 ist ein HOMO-LUMO-Niveau-Diagramm eines Bauelements gemäß dem zweiten Ausführungsbeispiel (Fig. 2B) dargestellt. Dabei befindet sich die Rekombinationszone zwischen dem p-Transportschichtsystem 52 und dem n-Transportschichtsystem 61.

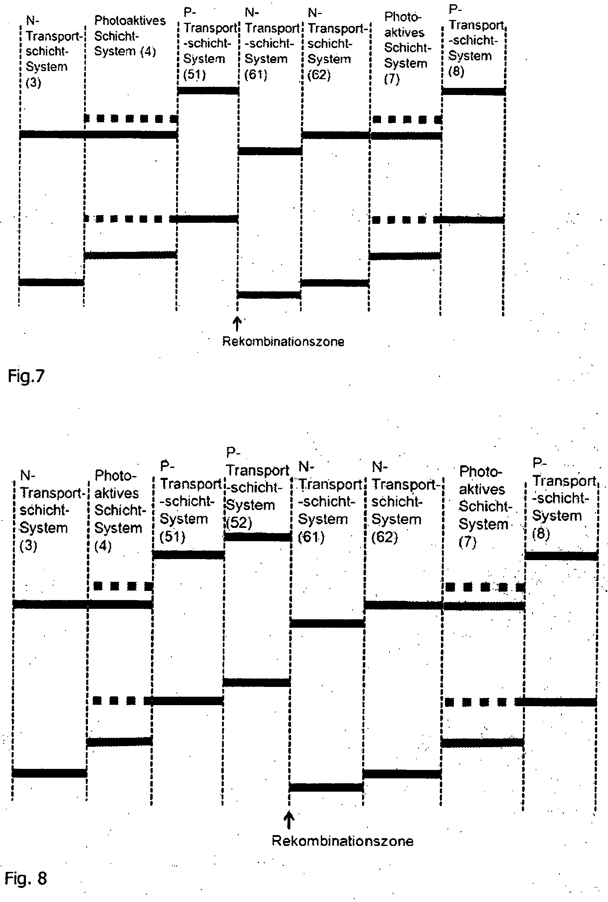

In der Fig. 7 ist ein HOMO-LUMO-Niveau-Diagramm eines Bauelements gemäß.einem weiteren Ausführungsbeispiel dargestellt. Dabei ist der Aufbau des Bauelements analog der zweiten Ausführungsform, wobei zwischen dem photoaktiven Schichtsystem 4 und dem Transportschichtsystem 61 ein Transportschichtsystem 51 angeordnet ist.

In der Fig. 8 ist ein HOMO-LUMO-Niveau-Diagramm eines Bauelements gemäß dem vierten Ausführungsbeispiels (Fig. 4B) dargestellt.

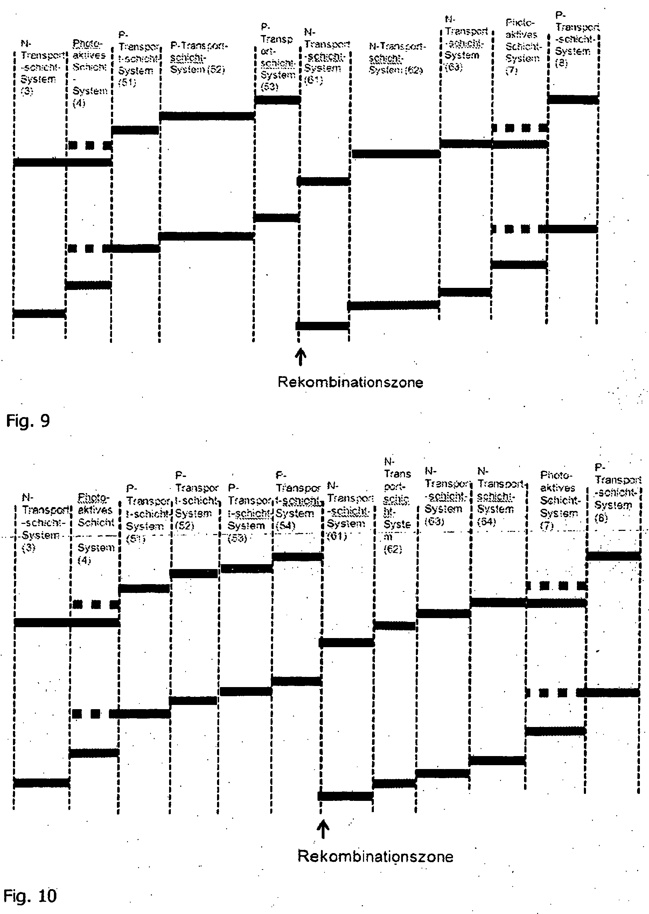

In der Fig. 9 ist ein HOMO-LUMO-Niveau-Diagramm eines Bauelements gemäß einem weiteren Ausführungsbeispiel dargestellt. Dabei ist das Transportschichtsystem 51 energetisch an das photoaktive Schichtsystem 4 und das Transportschichtsystem 63 energetisch an das photoaktive Schichtsystem 7 angepasst. Die Transportschichtsystem 52 und 62 verfügen über gute Transporteigenschaften und können eine größere Schichtdicke (20nm bis 400nm) als die Transportschichtsysteme 51,53,61 und 63 haben. Die Transportschichtsysteme 53 und 61 ermöglichen eine effiziente Rekombination von Ladungsträgern.

In der Fig. 10 ist ein HOMO-LUMO-Niveau-Diagramm eines Bauelements gemäß einem weiteren Ausführungsbeispiel dargestellt. Dabei ist der Aufbau des Bauelements analog der Fig. 9, wobei noch zwei weitere Transportschichtsysteme vorhanden sind.

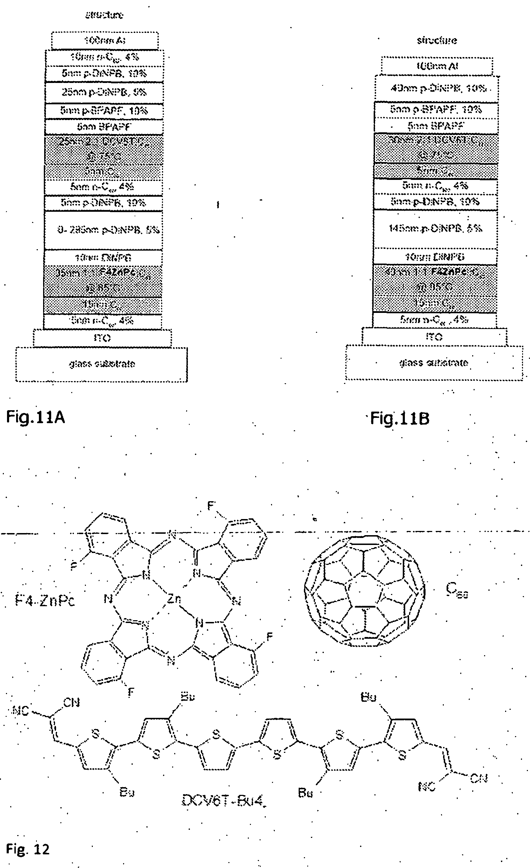

In einem weiteren Ausführungsbeispiel zeigen die Fig.11A und B den schematischen Schichtaufbau von zwei beispielhaften photoaktiven Bauelementen. Dabei sind im jeweiligen Diagramm die Angaben der Schichtdicken in nm angegeben, die Angaben der Dotierungskonzentration in %, die Angabe der Mischungsverhältnisse als Volumenverhältnis X:Y (z.B. 2:1) und die Angabe der Substrattemperatur während der Verdampfung in °C. Die beiden dotierten DiNPB Schichten (p-DiNPB) zwischen den Absorbersystemen (Absorbersystem 1: Mischschicht BDR001:C60; Absorbersystem 2: Mischschicht DC6T:C60) enthalten verschiedene Dotanden (Dotand 1 in einer Konzentration von 5% und Dotand 2 in einer Konzentration von 10%). Das Material BPAPF bezeichnet dabei 9,9-Bis(4-(N,N-bis-biphenyl-4-yl-amino)phenyl)-9H-fluoren und das Material DiNPB ist N,N'-Diphenyl-N,N'-bis(4'-(N,N-bis(naphth-1-yl)-amino)-biphenyl-4-yl)-benzidin.

Die: Strukturformel der Materialien DCV6T, F4-ZnPc und C60 sind in der Fig. 12 dargestellte.

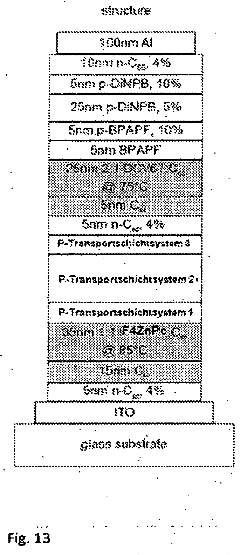

In einem weiteren Ausführungsbeispiel ist in der Fig. 13 der schematische Schichtaufbau eines beispielhaften photoaktiven Bauelementes analog zu Fig. 11 dargestellt: Zwischen den photoaktiven Absorbersystemen sind drei verschiedene p-Transportschichtsysteme 1, 2 und 3 angeordnet.

## Patentansprüche

1. Photoaktives Bauelement mit einer Elektrode und einer Gegenelektrode, wobei zwischen den Elektroden zumindest ein organisches Schichtsystem angeordnet ist, weiterhin mit mindestens zwei photoaktiven Schichtsystemen (4,7) und zwischen den photoaktiven Schichtsystemen (4,7) zumindest zwei verschiedene Transportschichtsysteme (51, 52) des gleichen Ladungsträgertyps, so dass zumindest ein Material, das zumindest eine der folgenden Eigenschaften der Transportschichtsysteme (51, 52) beeinflusst:
- Energetische Anpassung
- Transporteigenschaften
- Transparenz
nur in einem der beiden Transportschichtsysteme (51, 52) enthalten ist und falls dieses zumindest eine Material ein Dotand ist in beide Transportschichtsysteme (51, 52) ein anderer Dotand enthalten ist, wobei das eine Transportschichtsystem (51 oder 52) energetisch an eines der beiden photoaktiven Schichtsysteme (4, 7) angepasst ist, so dass sich eine Transportenergieniveaulage des Transportschichtsystem (51 oder 52) von einer Transportenergieniveaulage des einen der beiden Schichtsysteme (4, 7) um weniger als 0,5 eV unterscheidet, wobei die Transportenergieniveaulage eines Transportschichtsystems (51, 52) die energetische Lage des energetisch höchsten HOMOs ist, falls es sich um ein p-Transportschichtsystem (51, 52) handelt, und die energetische Lage des energetisch tiefsten LUMOs ist, falls es sich um ein n-Transportschichtsystem (51, 52) handelt, und das andere Transportschichtsystem (52 oder 51) transparent ausgeführt ist, wobei ein Material beziehungsweise ein Materialfilm beziehungsweise ein Transportschichtsystem transparent ist, wenn zumindest eine der folgenden Bedingungen zutrifft:
- Der energetische Abstand zwischen LUMO und HOMO des Materials beziehungsweise des Materialfilms beziehungsweise des Transportschichtsystems ist größer als 2,5 eV,
- Ein 50 nm dicker Film des Material beziehungsweise des Transportschichtsystems hat eine Transparenz von größer als 70% im Wellenlängenbereich von 400 bis 900 nm,
- Das Material beziehungsweise der Materialfilm beziehungsweise das Transportschichtsystem hat einen Extinktionskoeffizient ε, welcher im Wellenlängenbereich zwischen 450 nm und 800 nm den Wert von 0,5x 10⁵ cm⁻¹ nicht überschreitet, und/oder das Material beziehungsweise der Materialfilm beziehungsweise das Transportschichtsystem hat einen Absorptionsindex k, welcher im Wellenlängenbereich zwischen 450 nm und 800 nm den Wert 0,1 nicht überschreitet,
- Das Material beziehungsweise der Materialfilm beziehungsweise das Transportschichtsystem weist eine größere optische Bandlücke auf als das photoaktive Schichtsystem.

2. Photoaktives Bauelement nach Anspruch 1, bei dem sich die Transportenergieniveaulage des Transportschichtsystems (51 oder 52) und die Transportenergieniveaulage des einen der beiden photoaktiven Schichtsysteme (4, 7) um 0,3 eV unterscheiden oder um 0,2 ev oder um 0,1 eV.

3. Photoaktives Bauelement nach Anspruch 1 oder 2, **dadurch gekennzeichnet, dass** das transparente Transportschichtsystem eine Leitfähigkeit >= 1*10⁻⁶ S/cm aufweist und/oder dotiert ist.

4. Photoaktives Bauelement nach Anspruch 3, **dadurch gekennzeichnet, dass** die beiden Transportschichtsysteme mit verschiedenen Dotanden dotiert ist.

5. Photoaktives Bauelement nach einem der Ansprüche 1 bis 4, **dadurch gekennzeichnet, dass** beide Transportschichtsysteme direkt aneinandergrenzen und/oder beide transparent sind.

6. Photoaktives Bauelement nach einem der Ansprüche 1 bis 5, **dadurch gekennzeichnet, dass** eins oder beide Transportschichtsysteme zumindest aus einem organischen Material oder einer Mischung von organischen Materialien bestehen.

7. Photoaktives Bauelement nach einem der Ansprüche 1 bis 6, **dadurch gekennzeichnet, dass** die Transportenergieniveaulagen des transparenten Transportschichtsystems im Bereich -5,5eV bis -4,5eV liegen, falls es sich um ein p-Transportschichtsystem handelt, und im Bereich -4,5eV bis -3,5eV, falls es sich um ein n-Transportschichtsystem handelt.

8. Photoaktives Bauelement nach einem der Ansprüche 1 bis 7, **dadurch gekennzeichnet, dass** eine oder beide Transportschichtsysteme undotiert oder teilweise dotiert oder komplett dotiert sind und die Dotierung einen Gradienten aufweist oder die Dotierung weist innerhalb der Schicht verschiedene Konzentrationen auf.

9. Photoaktives Bauelement nach einem der Ansprüche 1 bis 8, **dadurch gekennzeichnet, dass** zwischen den photoaktiven Schichtsystemen (4, 7) noch ein weiteres Transportschichtsystem (61) des anderen Ladungsträgertyps vorhanden ist.

10. Photoaktives Bauelement nach einem der Ansprüche 1 bis 8, **dadurch gekennzeichnet, dass** zwischen den photoaktiven Schichtsystemen (4, 7) noch zwei weitere Transportschichtsysteme (61, 62) des anderen Ladungsträgertyps vorhanden sind, wobei das eine Transportschichtsystem (62) energetisch an das photoaktive Schichtsystem (4, 7) angepasst ist, so dass sich eine Transportenergieniveaulage des Transportschichtsystems (62) von einer Transportenergieniveaulage des anderen photoaktiven Schichtsystems (4, 7) um weniger als 0,5eV unterscheidet, und dass das zweite Transportschichtsystem (61) transparent ist.

11. Photoaktives Bauelement nach einem der Ansprüche 9 oder 10, **dadurch gekennzeichnet, dass** eine oder beide der weiteren Transportschichtsysteme (61, 62) Einzelschichten sind, Mischschicht sind, undotiert sind, teilweise dotiert sind, komplett dotiert sind, die Dotierung einen Gradienten aufweist, die Dotierung innerhalb der Schicht verschiedene Konzentrationen aufweist und/oder mit verschiedenen Dotanden dotiert ist.

12. Photoaktives Bauelement nach einem der Ansprüche 1 bis 11, **dadurch gekennzeichnet, dass** zwischen dem photoaktiven Schichtsystem (4) und der Elektrode (2) und/oder zwischen dem photoaktiven Schichtsystem (7) und der Gegenelektrode (9) mindestens zwei Transportschichtsysteme (31, 32 beziehungsweise 81, 82) vorhanden sind, wobei das eine Transportschichtsystem energetisch an das jeweilige photoaktive Schichtsystem angepasst ist, so dass sich eine Transportenergieniveaulage des Transportschichtsystem von einer Transportenergielage des jeweiligen photoaktoven Schichtsystems (4, 7) um weniger als 0,5eV unterscheidet, und dass das zweite Transportschichtsystem transparent ist.

13. Photoaktives Bauelement nach einem der Ansprüche 1 bis 12, **dadurch gekennzeichnet, dass** zwischen dem photoaktiven Schichtsystem (4) und der Elektrode (2) und/oder zwischen dem photoaktiven Schichtsystem (7) und der Gegenelektrode (9) mindestens drei Transportschichtsysteme (31, 32, 33 beziehungsweise 81, 82, 83) vorhanden sind, wobei das eine Transportschichtsystem energetisch an das jeweilige photoaktive Schichtsystem angepasst ist, so dass sich eine Transportenergieniveaulage des Transportschichtsystems einer Transportenergieniveaulage des jeweiligen photoaktiven Schichtsystems um weniger als 0,5eV unterscheidet, das zweite Transportschichtsystem transparent ist und das dritte Transportschichtsystem energetisch an die Elektrode beziehungsweise an die Gegenelektrode angepasst ist, so dass sich eine Transportenergieniveaulage des dritten Transportschichtsystems von einer Transportenergieniveaulage der Elektrode beziehungsweise der Gegenelektrode um weniger als 0,5eV unterscheidet.

14. Photoaktives Bauelement nach einem der Ansprüche 1 bis 13, **dadurch gekennzeichnet, dass** die im Bauelement vorhandenen Transportschichtsysteme unabhängig voneinander als Einzelschichten oder Mischschichten ausgeführt sind oder aus Nanoclustern bestehen; transparent oder semitransparent ausgeführt sind; undotiert oder teilweise dotiert oder komplett dotiert sind, wobei die Dotierung einen Gradienten aufweist oder die Dotierung innerhalb der Schicht verschiedene Konzentrationen aufweist und/oder die Transportschichtsysteme mit verschiedenen Dotanden dotiert ist.

15. Photoaktives Bauelement nach einem der Ansprüche 1 bis 14, **dadurch gekennzeichnet, dass** das Bauelement eine Tandem- oder Mehrfachzelle ist.

16. Photoaktives Bauelement nach einem der Ansprüche 1 bis 15, **dadurch gekennzeichnet, dass** das Bauelement aus einer Kombination aus nip, ni, ip, pnip, pni, pip, nipn, nin, ipn, pnipn, pnin oder pipn-Strukturen besteht, bei der zwei oder mehrere unabhängige Kombinationen, die mindestens eine i-Schicht enthalten, übereinander gestapelt sind.

17. Verwendung eines photoaktiven Bauelements gemäß einem der Ansprüche 1 bis 17 auf ebenen, gekrümmten oder flexiblen Trägerflächen.

## Claims

1. Photoactive component comprising an electrode and a counterelectrode, wherein at least one organic layer system is arranged between the electrodes, furthermore comprising at least two photoactive layer systems (4, 7) and between the photoactive layer systems (4, 7) at least two different transport layer systems (51, 52) of the same charge carrier type, such that at least one material which influences at least one of the following properties of the transport layer systems (51, 52):
- energetic matching
- transport properties
- transparency
is contained only in one of the two transport layer systems (51, 52) and, if said at least one material is a dopant, both transport layer systems (51, 52) contain another dopant, wherein one transport layer system (51 or 52) is energetically matched to one of the two photoactive layer systems (4, 7), such that a transport energy level position of the transport layer system (51 or 52) differs from a transport energy level position of said one of the two layer systems (4, 7) by less than 0.5 eV, wherein the transport energy level position of a transport layer system (51, 52) is the energetic position of the energetically highest HOMO if a p-type transport layer system (51, 52) is involved, and is the energetic position of the energetically lowest LUMO if an n-type transport layer system (51, 52) is involved, and the other transport layer system (52 or 51) is embodied as transparent, wherein a material or a material film or a transport layer system is transparent if at least one of the following conditions applies:
- the energetic separation between LUMO and HOMO of the material or the material film or of the transport layer system is greater than 2.5 eV,
- a 50 nm thick film of the material or of the transport layer system has a transparency of greater than 70% in the wavelength range of 400 to 900 nm,
- the material or the material film or the transport layer system has an extinction coefficient ε which does not exceed the value of 0.5 × 105 cm-1 in the wavelength range of between 450 nm and 800 nm, and/or the material or the material film or the transport layer system has an absorption index k which does not exceed the value 0.1 in the wavelength range of between 450 nm and 800 nm,
- the material or the material film or the transport layer system has a greater optical band gap than the photoactive layer system.

2. Photoactive component according to Claim 1, wherein the transport energy level position of the transport layer system (51 or 52) and the transport energy level position of said one of the two photoactive layer systems (4, 7) differ by 0.3 eV or by 0.2 eV or by 0.1 eV.

3. Photoactive component according to Claim 1 or 2, **characterized in that** the transparent transport layer system has a conductivity of greater than or equal to 1*10-6 S/cm and/or is doped.

4. Photoactive component according to Claim 3, **characterized in that** the two transport layer systems are doped with different dopants.

5. Photoactive component according to any of Claims 1 to 4, **characterized in that** both transport layer systems directly adjoin one another and/or are both transparent.

6. Photoactive component according to any of Claims 1 to 5, **characterized in that** one or both transport layer systems consist(s) at least of one organic material or of a mixture of organic materials.

7. Photoactive component according to any of Claims 1 to 6, **characterized in that** the transport energy level positions of the transparent transport layer system are in the range of -5.5 eV to -4.5 eV if a p-type transport layer system is involved, and in the range of -4.5 eV to -3.5 eV if an n-type transport layer system is involved.

8. Photoactive component according to any of Claims 1 to 7, **characterized in that** one or both transport layer systems is or are undoped or partly doped or completely doped and the doping has a gradient or the doping has different concentrations within the layer.

9. Photoactive component according to any of Claims 1 to 8, **characterized in that** one further transport layer system (61) of the other charge carrier type is also present between the photoactive layer systems (4, 7).

10. Photoactive component according to any of Claims 1 to 8, **characterized in that** two further transport layer systems (61, 62) of the other charge carrier type are also present between the photoactive layer systems (4, 7), wherein one transport layer system (62) is energetically matched to the photoactive layer system (4, 7), such that a transport energy level position of the transport layer system (62) differs from a transport energy level position of the other photoactive layer system (4, 7) by less than 0.5 eV, and wherein the second transport layer system (61) is transparent.

11. Photoactive component according to either of Claims 9 and 10, **characterized in that** one or both of the further transport layer systems (61, 62) is or are individual layers, is or are a mixed layer, is or are undoped, is or are partly doped, is or are completely doped, the doping has a gradient, the doping has different concentrations within the layer and/or is doped with different dopants.

12. Photoactive component according to any of Claims 1 to 11, **characterized in that** at least two transport layer systems (31, 32 and/or 81, 82) are present between the photoactive layer system (4) and the electrode (2) and/or between the photoactive layer system (7) and the counterelectrode (9), wherein one transport layer system is energetically matched to the respective photoactive layer system, such that a transport energy level position of the transport layer system differs from a transport energy level position of the respective photoactive layer system (4, 7) by less than 0.5 eV, and wherein the second transport layer system is transparent.

13. Photoactive component according to any of Claims 1 to 12, **characterized in that** at least three transport layer systems (31, 32, 33 and/or 81, 82, 83) are present between the photoactive layer system (4) and the electrode (2) and/or between the photoactive layer system (7) and the counterelectrode (9), wherein one transport layer system is energetically matched to the respective photoactive layer system, such that a transport energy level position of the transport layer system differs from a transport energy level position of the respective photoactive layer system by less than 0.5 eV, the second transport layer system is transparent and the third transport layer system is energetically matched to the electrode and/or to the counterelectrode, such that a transport energy level position of the third transport layer system differs from a transport energy level position of the electrode and/or of the counterelectrode by less than 0.5 eV.

14. Photoactive component according to any of Claims 1 to 13, **characterized in that** the transport layer systems present in the component, independently of one another, are embodied as individual layers or mixed layers or consist of nanoclusters; are embodied as transparent or semitransparent; are undoped or partly doped or completely doped, wherein the doping has a gradient or the doping has different concentrations within the layer and/or the transport layer systems are doped with different dopants.

15. Photoactive component according to any of Claims 1 to 14, **characterized in that** the component is a tandem or multiple cell.

16. Photoactive component according to any of Claims 1 to 15, **characterized in that** the component consists of a combination of nip, ni, ip, pnip, pni, pip, nipn, nin, ipn, pnipn, pnin or pipn structures in which two or a plurality of independent combinations containing at least one i-layer are stacked one above another.

17. Use of a photoactive component according to any of Claims 1 to 16 on planar, curved or flexible carrier surfaces.

## Revendications

1. Composant photoactif doté d'une électrode et d'une contre-électrode, au moins un système de couches organiques étant disposé entre les électrodes, le composant comportant en outre au moins deux systèmes (4, 7) de couches photoactives et au moins deux systèmes (51, 52) de couches de transport différents du même type de porteurs de charge entre les systèmes (4, 7) de couches photoactives, de telle sorte qu'au moins un matériau qui agit sur au moins l'une des propriétés suivantes des systèmes (51, 52) de couches de transport :
- adaptation énergétique,
- propriétés de transport,
- transparence,
ne soit repris que dans l'un des deux systèmes (51, 52) de couches de transport, un autre agent de dopage étant repris dans les deux systèmes (51, 52) de couches de transport au cas où ce ou ces matériaux sont un agent de dopage, ce système (51 ou 52) de couches de transport étant adapté énergétiquement à l'un des deux systèmes (4, 7) de couches photoactives de telle sorte que le niveau d'énergie de transport du système (51 ou 52) de couches de transport se distingue de moins de 0,5 eV du niveau d'énergie de transport de l'un des deux systèmes (4, 7) de couches, le niveau d'énergie de transport d'un système (51, 52) de couches de transport étant le niveau énergétique du HOMO énergétiquement le plus élevé au cas où le système (51, 52) de couches de transport est un système p et est le niveau énergétique du LUMO énergétiquement le plus bas au cas où le système (51, 52) de couches de transport est un système n, l'autre système (52 ou 51) de couches de transport étant transparent, un matériau ou un film de matériau ou un système de couches de transport étant transparent si au moins l'une des conditions suivantes est remplie :
- le niveau énergétique entre le LUMO et le HOMO du matériau ou du film de matériau du système de couches de transport est supérieur à 2,5 eV,
- un film d'une épaisseur de 50 nm du matériau ou du système de couches de transport présente une transparence supérieure à 70 % dans une plage de longueurs d'onde de 400 à 900 nm,
- le matériau, le film de matériau ou le système de couches de transport présentent un coefficient d'extinction ε qui ne descend pas en dessous de la valeur de 0,5 x 105 cm-1 dans la plage de longueurs d'onde comprises entre 450 nm et 800 nm et/ou le matériau, le film de matériau ou le système de couches de transport présentent un indice d'absorption K qui ne dépasse pas la valeur 0,1 dans la plage de longueurs d'onde comprises entre 450 nm et 800 nm et
- le matériau, le film de matériau ou le système de couches de transport présentent un interstice de bande optique supérieur à celui du système de couches photoactives.

2. Composant photoactif selon la revendication 1, dans lequel le niveau d'énergie de transport du système (51 ou 52) de couches de transport et le niveau d'énergie de transport de l'un des deux systèmes (4, 7) de couches photoactives se distinguent de 0,3 eV, de 0,2 eV ou de 0,1 eV.

3. Composant photoactif selon les revendications 1 ou 2, **caractérisé en ce que** le système de couches de transport présente une conductivité >=1*10-6 S/cm et/ou est dopé.

4. Composant photoactif selon la revendication 3, **caractérisé en ce que** les deux systèmes de couches de transport sont dopés avec des agents de dopage différents.

5. Composant photoactif selon l'une des revendications 1 à 4, **caractérisé en ce que** les deux systèmes de couches de transport sont directement adjacents l'un à l'autre et/ou sont tous deux transparents.

6. Composant photoactif selon l'une des revendications 1 à 5, **caractérisé en ce que** l'un ou les deux systèmes de couches de transport sont constitués au moins d'un matériau organique ou d'un mélange de matériaux organiques.

7. Composant photoactif selon l'une des revendications 1 à 6, **caractérisé en ce que** les niveaux d'énergie de transport du système de couches de transport transparent sont situés entre 5,5 eV à -4,5 eV au cas où le système de couches de transport est un système p et entre - 4,5 eV à -3,5 eV au cas où le système de couches de transport est un système n.

8. Composant photoactif selon l'une des revendications 1 à 7, **caractérisé en ce que** l'un ou les deux systèmes de couches de transport ne sont pas dopés, sont partiellement dopés ou sont complètement dopés et **en ce que** le dopage présente un gradient ou **en ce que** le dopage présente différentes concentrations à l'intérieur de la couche.

9. Composant photoactif selon l'une des revendications 1 à 8, **caractérisé en ce qu'**encore un autre système (61) de couches de transport de l'autre type de porteurs de charge est prévu entre les deux systèmes (4, 7) de couches photoactives.

10. Composant photoactif selon l'une des revendications 1 à 8, **caractérisé en ce qu'**encore deux autres systèmes (61, 62) de couches de transport de l'autre type de porteurs de charge sont prévus entre les systèmes (4, 7) de couches photoactives, un des systèmes (62) de couches de transport étant adapté énergétiquement au système (4, 7) de couches photoactives de telle sorte que le niveau d'énergie de transport du système (62) de couches de transport se distingue du niveau d'énergie de transport de l'autre système (4, 7) de couches photoactives de moins de 0,5 eV et **en ce que** le deuxième système (61) de couches de transport est transparent.

11. Composant photoactif selon l'une des revendications 9 ou 10, **caractérisé en ce qu'**un ou les deux autres systèmes (61, 62) de couches de transport sont des couches individuelles, des couches mixtes, ne sont pas dopés, sont dopés partiellement ou son dopés complètement, le dopage présentant un gradient, le dopage présentant différentes concentrations à l'intérieur de la couche et/ou la couche étant dopée à l'aide de différents agents de dopage.

12. Composant photoactif selon l'une des revendications 1 à 11, **caractérisé en ce qu'**au moins deux systèmes (31, 32 ou 81, 82) de couches de transport sont prévus entre le système (4) de couches de transport photoactives et l'électrodes (2) et/ou entre le système (7) de couches photoactives et la contre-électrode (9), l'un des systèmes de couches de transport étant adapté énergétiquement aux systèmes de couches photoactives respectifs de telle sorte que le niveau d'énergie de transport du système de couches de transport ne se distingue du niveau d'énergie de transport du système (4, 7) de couches photoactives respectif de moins que 0,5 eV et **en ce que** le deuxième système de couches de transport est transparent.

13. Composant photoactif selon l'une des revendications 1 à 12, **caractérisé en ce qu'**au moins trois systèmes (31, 32, 33 ou 81, 82, 83) de couches de transport sont prévus entre le système (4) de couches de transport photoactives et l'électrode (2) et/ou entre le système (7) de couches photoactives et la contre-électrode (9), le système de couches de transport étant adapté énergétiquement au système de couches photoactives respectif de telle sorte que le niveau d'énergie de transport du système de couches de transport ne se distingue du niveau d'énergie de transport du système de couches photoactives respectif que de moins que 0,5 eV, le deuxième système de couches de transport étant transparent et le troisième système de couches de transport étant adapté énergétiquement à l'électrode ou à la contre-électrode de telle sorte que le niveau d'énergie de transport du troisième système de couches de transport ne se distingue du niveau d'énergie de transport de l'électrode ou de la contre-électrode que de moins que 0,5 eV.

14. Composant photoactif selon l'une des revendications 1 à 13, **caractérisé en ce que** les systèmes de couches de transport prévus dans le composant sont réalisés indépendamment les uns des autres sous la forme de couches individuelles ou de couches mixtes ou sont constitués de nano-amas, sont transparents ou sont semi-transparents, sont dopés, partiellement dopés ou complètement dopés, le dopage présentant un gradient ou le dopage présentant différentes concentrations à l'intérieur de la couche et/ou les systèmes de couches de transport étant dopés à l'aide de différents agents de dopage.

15. Composant photoactif selon l'une des revendications 1 à 14, **caractérisé en ce que** le composant est une cellule tandem ou multiple.

16. Composant photoactif selon l'une des revendications 1 à 15, **caractérisé en ce que** le composant est constitué d'une combinaison de structures nip, ni, ip, pnip, pni, pip, nipn, nin, ipn, pnipn, pnin ou pipn, dans laquelle deux ou plusieurs combinaisons indépendantes qui contiennent au moins une couche i sont superposées les unes aux autres.

17. Utilisation d'un composant photoactif selon l'une des revendications 1 à 16 sur des surfaces de support planes, courbées ou flexibles.
